(19) Europäisches Patentamt / European Patent Office / Office européen des brevets

(11) **EP 4 300 754 B1**

(12) **EUROPEAN PATENT SPECIFICATION**

(45) Date of publication and mention
of the grant of the patent:
**24.06.2026  Bulletin 2026/26**

(21) Application number: **21932258.3**

(22) Date of filing: **26.03.2021**

(51) International Patent Classification (IPC):
*G01R 31/36* (2020.01)     *G01R 31/40* (2020.01)
*H02J 7/00* (2026.01)     *H02J 7/56* (2026.01)
*H02J 7/90* (2026.01)

(52) Cooperative Patent Classification (CPC):
**H02J 7/56; G01R 31/36; G01R 31/40; H02J 7/933;**
H02J 2207/20

(86) International application number:
**PCT/CN2021/083274**

(87) International publication number:
**WO 2022/198635 (29.09.2022 Gazette 2022/39)**

(54) **ENERGY STORAGE SYSTEM AND CONTROL METHOD THEREFOR**

ENERGIESPEICHERSYSTEM UND STEUERUNGSVERFAHREN DAFÜR

SYSTÈME DE STOCKAGE D'ÉNERGIE ET PROCÉDÉ DE COMMANDE ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.01.2024  Bulletin 2024/01**

(73) Proprietor: **Huawei Digital Power Technologies
Co., Ltd.
Shenzhen, Guangdong 518043 (CN)**

(72) Inventors:
• **WU, Zhipeng**
**Shenzhen, Guangdong 518129 (CN)**
• **SHEN, Yanbai**
**Shenzhen, Guangdong 518129 (CN)**
• **YU, Shijiang**
**Shenzhen, Guangdong 518129 (CN)**

(74) Representative: **Maiwald GmbH
Engineering
Elisenhof
Elisenstrasse 3
80335 München (DE)**

(56) References cited:
EP-A1- 3 370 322     EP-A1- 3 591 823
EP-B1- 2 779 348     WO-A1-2013/145658
CN-A- 102 447 285     CN-A- 107 431 373
CN-A- 108 539 841     US-A1- 2011 144 822
US-A1- 2013 038 289     US-A1- 2013 127 399
US-A1- 2013 234 669     US-A1- 2019 317 151
US-A1- 2019 334 349

## Description

## TECHNICAL FIELD

This application relates to the field of battery energy storage technologies, and in particular, to an energy storage system and a control method thereof.

## BACKGROUND

With occurrence of environmental problems and continuous exhaustion of fossil fuel reserves, renewable energy such as wind energy and solar energy gradually becomes a main research direction. Although new clean energy in wind power generation, photovoltaic power generation, and the like has an innate advantage of being inexhaustible, such energy is affected by terrains, climates, and environments, and therefore has disadvantages of low stability and low reliability. Based on this, energy storage technologies have emerged. The essence of energy storage technologies is conversion of energy forms. Energy may be stored in various media, and then converted into electric energy when needed. In the smart grid field and the automobile field, an energy storage system in which a battery is used as an energy storage device has a good development prospect. Generally, different energy storage systems have different rated charge/discharge rates. To adapt to various charge/discharge rate scenarios, current energy storage systems are mostly developed in a customized manner. For example, in the case of a same battery capacity, to match with different rated charge/discharge rates, power converters of different specifications need to be designed. As a result, power converter specifications are numerous, and development costs are comparatively high. Therefore, how to design an energy storage system compatible with different rated charge/discharge rates and reduce development costs becomes one of problems to be urgently resolved at present.

US 2013/0038289 A1 describes a battery-cell converter system.

US 2011/0144822 A1 describes a grid-connected energy storage system.

EP 3 591 823 A1 describes a combined DC-DC converter for use in hybrid power systems.

US 2019/317151 A1 describes an electrochemical impedance spectroscopy analyzer battery performance database.

US 2013/0127399 A1 describes a cell balancing system.

US 2019/334349 A1 describes a DC/DC converter for distributed storage and solar systems.

EP 2 779 348 B1 describes an apparatus for storing an depleting energy.

EP 3 370 322 A1 describes a power conversion system.

US 2013/0234669 A1 describes an intelligent integrated battery module.

WO 2013/145658 A1 describes a charging/-discharging control apparatus.

## SUMMARY

This application provides an energy storage system and a control method thereof, which can be compatible with different rated charge/discharge rates, thereby reducing development costs of an energy storage system and achieving high applicability.

The present invention is defined by the subject-matter of the independent claims. Additional features of the invention are presented in the dependent claims.

According to a first aspect, this application provides an energy storage system. The energy storage system includes at least one battery cluster, at least two direct current DC/DC conversion modules, and a control unit. An output end of each of the at least one battery cluster is connected to an input end of each of the at least two DC/DC conversion modules by using a switch, and output ends of the at least two DC/DC conversion modules are connected in parallel to a direct current bus. The control unit is connected to the at least one battery cluster and each of the at least two DC/DC conversion modules by using a control bus, to control charging and discharging of the at least one battery cluster and control each of the at least two DC/DC conversion modules to perform direct current conversion. The control unit is further configured to control turn-on or turn-off of a switch used by each of the at least one battery cluster to connect to each of the at least two DC/DC conversion modules, to control connections between each of the at least one battery cluster and different quantities of DC/DC conversion modules, thereby controlling a rated charge/discharge rate of the energy storage system. It can be understood that the DC/DC conversion module may be a bidirectional DC/DC conversion circuit. The switch may be a circuit breaker, a contactor, or the like.

In this application, from the perspective of a connection relationship, each battery cluster included in the energy storage system may be connected to the DC/DC conversion modules; during actual running, turn-on and turn-off of switches used for connections between each battery cluster and the DC/DC conversion modules are controlled by using the control unit, so as to control a quantity of DC/DC conversion modules correspondingly connected to each battery cluster, thereby controlling the rated charge/discharge rate of the energy storage system. Usually, the rated charge/discharge rate of the energy storage system is directly proportional to a quantity of DC/DC conversion modules correspondingly connected to the battery cluster in the energy storage system. For example, there is one battery cluster. In this case, when the battery cluster is correspondingly connected to one DC/DC conversion module, the rated charge/discharge rate of the energy storage system is XC; or when the battery cluster is correspondingly connected to n DC/DC conversion modules, the rated charge/discharge rate of the energy storage system is nXC, where n is an integer greater than 1. A specific value of X is determined based on a matching status between a rated capacity of the battery cluster and rated operating power of the DC/DC conversion module. In other words, the value of X is determined based on specifications of the battery cluster and the DC/DC conversion module.

With reference to the first aspect, the at least one battery cluster includes a first battery cluster; and the control unit is configured to control a switch, which is used by the first battery cluster to connect to a first DC/DC conversion module in the at least two DC/DC conversion modules, to be turned on, and control a switch, which is used by the first battery cluster to connect to a DC/DC conversion module that is other than the first DC/DC conversion module and that is in the at least two DC/DC conversion modules, to be turned off, thereby controlling a charge/discharge current of the energy storage system, so that the rated charge/discharge rate of the energy storage system is a first rated charge/discharge rate.

In this application, if each battery cluster included in the energy storage system joins in running (that is, each battery cluster is correspondingly connected to a DC/DC conversion module), each battery cluster in the energy storage system is correspondingly connected to a same quantity of DC/DC conversion modules, and one connected DC/DC conversion module can correspond to only one battery cluster. Herein, the first battery cluster is used as an example. When the first battery cluster is correspondingly connected to one DC/DC conversion module (that is, the first DC/DC conversion module), the rated charge/discharge rate of the energy storage system is XC, where a magnitude of X is determined based on specifications of the battery cluster and the DC/DC conversion module.

With reference to the first possible implementation of the first aspect, in a second possible implementation, the control unit is further configured to control switches, which are used by the first battery cluster to connect to n DC/DC conversion modules in the at least two DC/DC conversion modules, to be turned on, and control a switch, which is used by the first battery cluster to connect to a DC/DC conversion module that is other than the n DC/DC conversion modules and that is in the at least two DC/DC conversion modules, to be turned off, thereby controlling a charge/discharge current of the energy storage system, so that the rated charge/-discharge rate of the energy storage system is a second rated charge/discharge rate, where the n DC/DC conversion modules or the another DC/DC conversion module include/includes the first DC/DC conversion module, the second rated charge/discharge rate is n times the first rated charge/discharge rate, and n is an integer greater than 1.

In this application, if each battery cluster included in the energy storage system joins in running (that is, each battery cluster is correspondingly connected to a DC/DC conversion module), each battery cluster in the energy storage system is correspondingly connected to a same quantity of DC/DC conversion modules, and one connected DC/DC conversion module can correspond to only one battery cluster. Herein, the first battery cluster is used as an example. When the first battery cluster is correspondingly connected to n DC/DC conversion modules, the rated charge/discharge rate of the energy storage system is nXC, where a magnitude of X is determined based on specifications of the battery cluster and the DC/DC conversion module.

With reference to the first aspect, in a third possible implementation, the energy storage system includes at least two battery clusters, and the at least two battery clusters include a first battery cluster and a second battery cluster. The control unit is configured to control a switch, which is used by the first battery cluster to connect to h DC/DC conversion modules in the at least two DC/DC conversion modules, to be turned on, control a switch, which is used by the first battery cluster to connect to a DC/DC conversion module that is other than the h DC/DC conversion modules and that is in the at least two DC/DC conversion modules, to be turned off, and control a switch, which is used by the second battery cluster to connect to each of the at least two DC/DC conversion modules, to be turned off, thereby controlling a charge/discharge current of the energy storage system, so that the rated charge/discharge rate of the energy storage system is a target rated charge/discharge rate, where h is an integer greater than 0.

In this application, if a battery cluster in the energy storage system does not join in running, that is, the battery cluster is not correspondingly connected to any DC/DC conversion module, a quantity of DC/DC conversion modules correspondingly connected to each running battery cluster is controlled to be 1 or greater than 1, so that different rated charge/discharge rates of the energy storage system can also be controlled.

With reference to any one of the first aspect, or the first to the third possible implementations of the first aspect, in a fourth possible implementation, the control unit is further configured to control charging and discharging of each battery cluster based on an output current magnitude and initial state of charge of the battery cluster, to balance remaining power of each battery cluster.

In this application, when the energy storage system includes at least two battery clusters that are in a running state (that is, each battery cluster is correspondingly connected to a same quantity of different DC/DC conversion modules), the control unit may control charging and discharging of each of the at least two battery clusters by using an output current magnitude and initial state of charge of the battery cluster that are obtained, to balance remaining power of each battery cluster, thereby reducing inconsistency between the battery clusters in charging and discharging processes, and avoiding overcharge and overdischarge of the battery cluster.

With reference to the fourth possible implementation of the first aspect, in a fifth possible implementation, each battery cluster includes at least one battery module connected in series, each battery module includes one battery management unit BMU, the control unit is connected to a BMU of each battery module in each battery cluster by using the control bus, and the control unit is configured to obtain an initial state of charge of each battery cluster by using a BMU of each battery module.

In this application, a BMU in each battery module in the battery cluster may be configured to monitor signals such as a cell voltage, a temperature, and an initial state of charge in the battery module, to implement charging and discharging management and control of each battery cluster, thereby avoiding damage to the battery cluster.

With reference to the fourth possible implementation of the first aspect, in a sixth possible implementation, each of the at least two DC/DC conversion modules includes one battery control unit BCU, the control unit is connected to each BCU in the DC/DC conversion modules by using the control bus, and the control unit is configured to obtain an output current magnitude of each battery cluster by using each BCU.

In this application, an output current of each battery cluster is collected based on a BCU included in each DC/DC conversion module, and may be used to implement charging and discharging management and control of each battery cluster, thereby helping improve stability and reliability of the energy storage system.

With reference to the fourth possible implementation of the first aspect, in a seventh possible implementation, the at least two DC/DC conversion modules include one battery control unit BCU, the control unit is connected to the BCU by using the control bus, and the control unit is configured to obtain an output current magnitude of each battery cluster by using the BCU.

In this application, one BCU is reused to collect output currents of all battery clusters, so that complexity of the energy storage system can be reduced, and applicability is high.

With reference to any one of the first aspect, or the first to the seventh possible implementations of the first aspect, in an eighth possible implementation, the energy storage system further includes a power converter, an input end of the power converter is connected to the direct current bus, an output end of the power converter is connected to an alternating current bus, and the power converter is configured to convert, into alternating current electricity during discharging of the battery cluster, direct current electricity that is input based on the direct current bus, or the power converter is configured to convert, into direct current electricity during charging of the battery cluster, alternating current electricity that is input based on the alternating current bus.

In this application, the power converter is configured to convert, into alternating current electricity during discharging of the battery cluster, direct current electricity that is input based on the direct current bus, or the power converter is configured to convert, into direct current electricity during charging of the battery cluster, alternating current electricity that is input based on the alternating current bus. This enhances applicability of the energy storage system.

According to a second aspect, this application provides an energy storage system control method. The method is applicable to an energy storage system. The energy storage system includes at least one battery cluster, at least two direct current DC/DC conversion modules, and a control unit. An output end of each of the at least one battery cluster is connected to an input end of each of the at least two DC/DC conversion modules by using a switch, output ends of the at least two DC/DC conversion modules are connected in parallel to a direct current bus, and the control unit is connected to the at least one battery cluster and each of the at least two DC/DC conversion modules by using a control bus. Specifically, the method includes: first, controlling turn-on or turn-off of a switch used by each of the at least one battery cluster to connect to each of the at least two DC/DC conversion modules, to control connections between each of the at least one battery cluster and different quantities of DC/DC conversion modules; then, obtaining an output current magnitude and initial state of charge of each battery cluster; and further, controlling charging and discharging of each battery cluster based on an output current magnitude and initial state of charge of the battery cluster, to balance remaining power of each battery cluster.

With reference to the second aspect, in a first possible implementation, the controlling charging and discharging of each battery cluster based on an output current magnitude and initial state of charge of the battery cluster includes: controlling, based on an output current magnitude and initial state of charge of each battery cluster, operating power of each DC/DC conversion module correspondingly connected to the battery cluster, to control charging and discharging of each battery cluster.

With reference to the first possible implementation of the second aspect, in a second possible implementation, the controlling, based on an output current magnitude and initial state of charge of each battery cluster, operating power of each DC/DC conversion module correspondingly connected to the battery cluster includes: determining, based on an output current magnitude and initial state of charge of any battery cluster, a first state of charge corresponding to the any battery cluster; and controlling, based on a first state of charge corresponding to each battery cluster, operating power of each DC/DC conversion module correspondingly connected to the battery cluster, to control charging and discharging of each battery cluster.

In this application, the control unit controls turn-on or turn-off of a switch used by the battery cluster to connect to each DC/DC conversion module, to enable a connection between the battery cluster and one or more DC/DC conversion modules, thereby controlling a rated charge/discharge rate of the energy storage system, so that the energy storage system can be compatible with different charge/discharge rates. In this way, development costs are reduced, and applicability is high. Further, in actual running, operating power of each DC/DC conversion module correspondingly connected to each battery cluster is controlled, to control charging and discharging of each battery cluster, thereby balancing remaining power of each battery cluster, and avoiding overcharge or overdischarge of the battery cluster. This helps improve stability and reliability of the energy storage system.

## BRIEF DESCRIPTION OF DRAWINGS

FIG. 1 is a schematic diagram of a system architecture of an energy storage system;
FIG. 2 is a schematic diagram of a structure of an energy storage system according to this application;
FIG. 3(a) to FIG. 3(c) are a schematic diagram of an application scenario of different rated charge/-discharge rates according to an embodiment of this application;
FIG. 4 is a schematic diagram of another structure of an energy storage system according to this application;
FIG. 5(a) to FIG. 5(d) are a schematic diagram of another application scenario of different rated charge/discharge rates according to an embodiment of this application;
FIG. 6 is a schematic diagram of another structure of an energy storage system according to this application;
FIG. 7 is a schematic diagram of another structure of an energy storage system according to this application;
FIG. 8 is a schematic diagram of another structure of an energy storage system according to this application;
FIG. 9 is a schematic flowchart of an energy storage system control method according to this application; and
FIG. 10 is a schematic diagram of controlling a DC/DC conversion module according to this application.

## DESCRIPTION OF EMBODIMENTS

An energy storage system provided in this application is applicable to a plurality of types of power generation devices such as a photovoltaic power generation device or a wind power generation device and different types of electric devices (such as a power grid, a household device, an industrial electric device, or a commercial electric device), and may be applied to the automobile field, the micro-grid field, and the like. The energy storage system provided in this application is applicable to energy storage of different types of electrochemical batteries. Herein, the different types of electrochemical batteries may include a lithium-ion battery, a lead-acid battery (also referred to as a lead-acid battery), a lead-carbon battery, a supercapacitor, a solid-state battery, a flow battery, and the like. A specific battery type is not specifically limited in this application. For ease of description, in this application, the energy storage system provided in this application is described by using a lithium battery as an example.

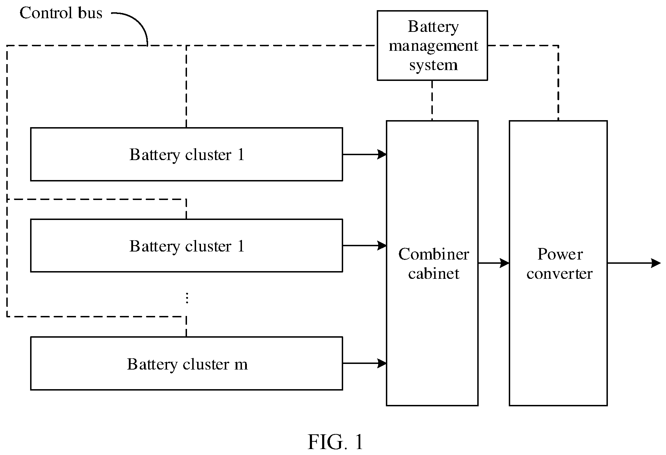

Energy storage systems are applied to an extensive range of scenarios, and are well applied in stages such as power generation, power transmission, power transformation, power distribution, and electricity consumption of power systems. Moreover, charge/discharge rates of energy storage systems are distributed in a wide range from 0.2C to 2C. Therefore, energy storage systems differ greatly. To adapt to a large quantity of charge/discharge rates, current energy storage systems are mostly developed in a customized manner, that is, one charge/discharge rate usually corresponds to one system structure and a converter of one specification. As a result, converter specifications are numerous, system costs are comparatively high, and a project development period is comparatively long. FIG. 1 is a schematic diagram of a system architecture of an energy storage system. The energy storage system shown in FIG. 1 includes a plurality of battery clusters (a battery cluster 1, a battery cluster 2, ..., and a battery cluster m that are shown in FIG. 1), a combiner cabinet, and a power converter. After the plurality of battery clusters are connected in parallel through the combiner cabinet, the plurality of battery clusters are connected to a direct current side of the power converter. An external battery management system (battery management system, BMS) is connected to each battery cluster, the combiner cabinet, and the power converter by using a control bus. The BMS is configured to collect battery information of each battery cluster and communicate with the combiner cabinet and the power converter, to perform charging and discharging control on the energy storage system. It can be understood that a charge/discharge rate is a current value required for a battery to discharge a rated capacity of the battery within a specified time, is equal to a multiple of the rated capacity of the battery in terms of a numerical value, and is usually represented by a letter C. Usually, a charge/discharge rate is equal to a charge/discharge current (in amperes) divided by a rated battery capacity (in ampere hours), or a charge/discharge rate is equal to charge/discharge power (in kilowatts) divided by a rated battery capacity (in kilowatt-hours).

For the energy storage system shown in FIG. 1, in the case of a same battery capacity, to match with different rated charge/discharge rates, power converters of different specifications need to be designed. As a result, power converter specifications are numerous, and development costs are comparatively high. In addition, in the energy storage system shown in FIG. 1, the battery clusters are connected in parallel through the combiner cabinet. Therefore, during actual running of the energy storage system shown in FIG. 1, charging and discharging of the battery clusters in the energy storage system can be controlled only in a unified manner. However, there is a difference/inconsistency between different battery clusters, for example, different battery clusters have different electrochemical characteristics, or performance and various parameters of different battery clusters change to different extents as a quantity of charge/discharge cycles increases. Therefore, in actual running, if charging and discharging of the battery clusters in the energy storage system can be controlled only in a unified manner, some of the battery clusters may be overcharged or overdischarged, which seriously affects a battery lifespan. This is not conducive to stable running of the energy storage system.

Based on this, this application proposes an energy storage system. The energy storage system is compatible with different rated charge/discharge rates, and can implement independent running management of each battery cluster in the energy storage system. The energy storage system includes at least one battery cluster, at least two direct current (direct current, DC)/DC conversion modules, and a control unit. Usually, the control unit may be a central monitoring unit (CMU) or the like. This is not limited herein. An output end of each of the at least one battery cluster is connected to an input end of each of the at least two DC/DC conversion modules by using a switch, and output ends of the at least two DC/DC conversion modules are connected in parallel to a direct current bus. The at least two DC/DC conversion modules may be integrated into one direct current converter. Therefore, that the output ends of the at least two DC/DC conversion modules are connected in parallel to the direct current bus may be understood as follows: Positive electrodes of all the at least two DC/DC conversion modules are connected in parallel, and negative electrodes of all the at least two DC/DC conversion modules are connected in parallel, so as to be used as an output end of the direct current converter to connect to the direct current bus. The control unit is connected to the at least one battery cluster and each of the at least two DC/DC conversion modules by using a control bus, to control charging and discharging of the at least one battery cluster and control each of the at least two DC/DC conversion modules to perform direct current conversion. It can be understood that the control unit is further configured to control turn-on or turn-off of a switch used by each of the at least one battery cluster to connect to each of the at least two DC/DC conversion modules, to control connections between each of the at least one battery cluster and different quantities of DC/DC conversion modules, thereby controlling a rated charge/discharge rate of the energy storage system.

It can be understood that, if each battery cluster included in the energy storage system joins in running (that is, each battery cluster is correspondingly connected to a DC/DC conversion module), each battery cluster in the energy storage system should be correspondingly connected to a same quantity of DC/DC conversion modules, and one connected DC/DC conversion module corresponds to one battery cluster. One battery cluster (that is, a first battery cluster) in the energy storage system is used as an example. The control unit is configured to control a switch, which is used by the first battery cluster to connect to a first DC/DC conversion module in the at least two DC/DC conversion modules, to be turned on, and control a switch, which is used by the first battery cluster to connect to a DC/DC conversion module that is other than the first DC/DC conversion module and that is in the at least two DC/DC conversion modules, to be turned off, thereby controlling a charge/discharge current of the energy storage system, so that the rated charge/discharge rate of the energy storage system is a first rated charge/discharge rate. That is, when the first battery cluster is correspondingly connected to one DC/DC conversion module (that is, the first DC/DC conversion module), the rated charge/discharge rate of the energy storage system is XC, where a magnitude of X is determined based on specifications of the battery cluster and the DC/DC conversion module.

Further, the control unit is further configured to control switches, which are used by the first battery cluster to connect to n DC/DC conversion modules in the at least two DC/DC conversion modules, to be turned on, and control a switch, which is used by the first battery cluster to connect to a DC/DC conversion module that is other than the n DC/DC conversion modules and that is in the at least two DC/DC conversion modules, to be turned off, thereby controlling a charge/discharge current of the energy storage system, so that the rated charge/discharge rate of the energy storage system is a second rated charge/discharge rate. The n DC/DC conversion modules or the another DC/DC conversion module include/includes the first DC/DC conversion module, the second rated charge/discharge rate is n times the first rated charge/discharge rate, and n is an integer greater than 1. That is, when the first battery cluster is correspondingly connected to n DC/DC conversion modules, the rated charge/discharge rate of the energy storage system is nXC, where a magnitude of X is determined based on specifications of the battery cluster and the DC/DC conversion module. During switching of the rated charge/discharge rate of the energy storage system, for example, switching the rated charge/discharge rate of the energy storage system from XC to nXC, a switch corresponding to (n-1) DC/DC conversion modules may be turned on in addition to turning on the switch corresponding to the first DC/DC conversion module, so that the first battery cluster is correspondingly connected to the n DC/DC conversion modules. Optionally, alternatively, the switch corresponding to the first DC/DC conversion module may be first turned off, and then switches corresponding to n DC/DC conversion modules are turned on, so that the first battery cluster is correspondingly connected to the n DC/DC conversion modules. This is not limited herein.

In other words, the control unit in this application controls turn-on or turn-off of a switch used by each battery cluster to connect to each DC/DC conversion module, to control connections between each battery cluster and different quantities of DC/DC conversion modules, thereby controlling the rated charge/discharge rate of the energy storage system. For example, the energy storage system includes one battery cluster. When the battery cluster is correspondingly connected to one DC/DC conversion module, the rated charge/discharge rate of the energy storage system is XC. When the battery cluster is correspondingly connected to n DC/DC conversion modules, the rated charge/discharge rate of the energy storage system is nXC. A specific value of X is determined based on a matching status between a rated capacity of the battery cluster and rated operating power of the DC/DC conversion module. In other words, X is determined based on specifications of the selected battery cluster and DC/DC conversion module. For example, it is assumed that a ratio of the rated operating power of the DC/DC conversion module in the energy storage system to the battery capacity of the battery cluster is 1:4. In this case, when the battery cluster is correspondingly connected to one DC/DC conversion module, the rated charge/discharge rate of the energy storage system is 0.25C, that is, X=0.25. Correspondingly, when the battery cluster is correspondingly connected to two DC/DC conversion modules, the rated charge/discharge rate of the energy storage system is 0.5C. The rest may be deduced by analogy. When the battery cluster is correspondingly connected to n DC/DC conversion modules, the rated charge/discharge rate of the energy storage system is 0.25nC. For another example, it is assumed that a ratio of the rated operating power of the DC/DC conversion module in the energy storage system to the battery capacity of the battery cluster is 1:2. In this case, when the battery cluster is correspondingly connected to one DC/DC conversion module, the rated charge/discharge rate of the energy storage system is 0.5C, that is, X=0.5. Correspondingly, when the battery cluster is correspondingly connected to two DC/DC conversion modules, the rated charge/discharge rate of the energy storage system is 1C. The rest may be deduced by analogy. When the battery cluster is correspondingly connected to n DC/DC conversion modules, the rated charge/discharge rate of the energy storage system is 0.5nC.

It can be understood that, in this embodiment of this application, the switch for connecting the battery cluster and the DC/DC conversion module may be a circuit breaker, a contactor, or the like. This is specifically determined based on an actual application scenario, and is not limited herein. The DC/DC conversion module is a bidirectional DC/DC conversion circuit, and all the DC/DC conversion modules in this application are the same. Usually, the bidirectional DC/DC conversion circuit may be a non-isolated bidirectional DC/DC conversion circuit, an isolated bidirectional DC/DC conversion circuit, or the like. This is not limited herein. The non-isolated bidirectional DC/DC conversion circuit may include a flying capacitor multilevel circuit, a three-level boost circuit, a four-switch buck-boost circuit, or the like. This is not limited herein. A switching device used in the DC/DC conversion circuit may be a metal-oxide semiconductor field-effect transistor (metal-oxide semiconductor field-effect transistor, MOSFET), an insulated gate bipolar transistor (insulated gate bipolar transistor, IGBT), or the like made of a material such as a semiconductor silicon (silicon, Si) material or silicon carbide (silicon carbide, SiC) or gallium nitride (gallium nitride, GaN) of a third-generation wide-bandgap semiconductor material. This is not limited herein.

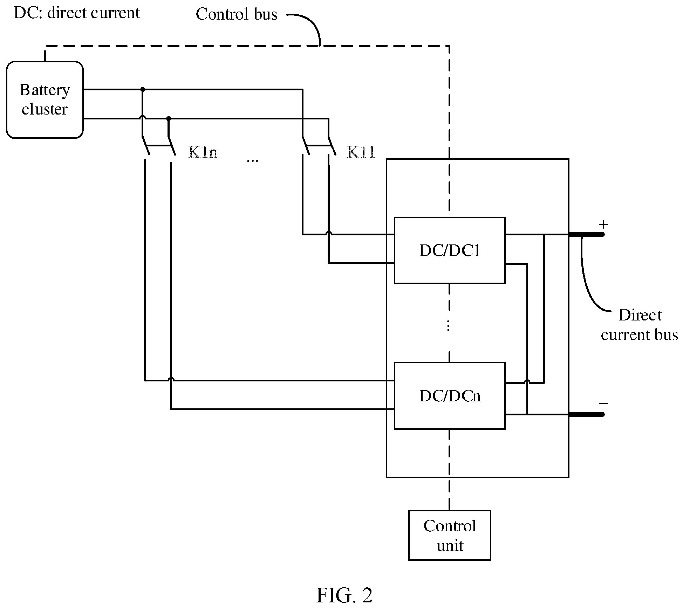

The following describes the energy storage system provided in this application and a working principle of the energy storage system by using examples with reference to FIG. 2 to FIG. 9.

FIG. 2 is a schematic diagram of a structure of an energy storage system according to this application. As shown in FIG. 2, the energy storage system includes one battery cluster, n DC/DC conversion modules, and a control unit, where n is an integer greater than 1. In other words, the n DC/DC conversion modules may be a DC/DC conversion module 1, ..., and a DC/DC conversion module n. An output end of the battery cluster may be connected to the DC/DC conversion module 1 (DC/DC1 shown in FIG. 2) by using a switch K11, the output end of the battery cluster may be further connected to a DC/DC conversion module 2 (not shown in FIG. 2) by using a switch K12 (not shown in FIG. 2), ..., and the output end of the battery cluster may be further connected to the DC/DC conversion module n (DC/DCn shown in FIG. 2) by using a switch K1n. The control unit may be connected to the battery cluster and each DC/DC conversion module by using a control bus. The control unit is configured to control turn-on or turn-off of a switch used by the battery cluster to connect to each DC/DC conversion module, to enable a connection between the battery cluster and one or more DC/DC conversion modules, thereby controlling a rated charge/discharge rate of the energy storage system. For example, n is equal to 2. In this case, when the control unit controls the battery cluster to correspondingly connect to one DC/DC conversion module, the rated charge/discharge rate of the energy storage system is XC; or when the control unit controls the battery cluster to correspondingly connect to two DC/DC conversion modules, the rated charge/discharge rate of the energy storage system is 2XC.

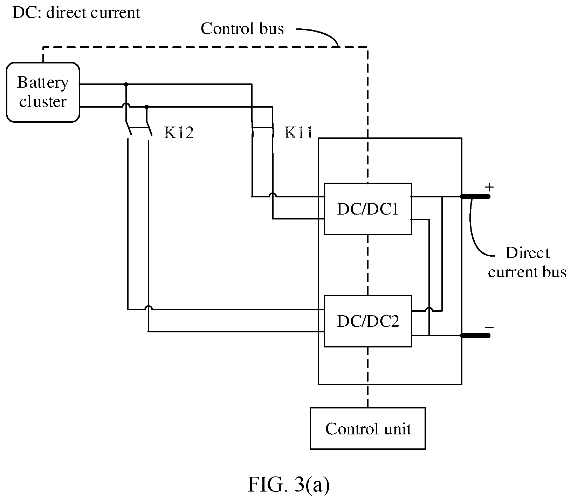

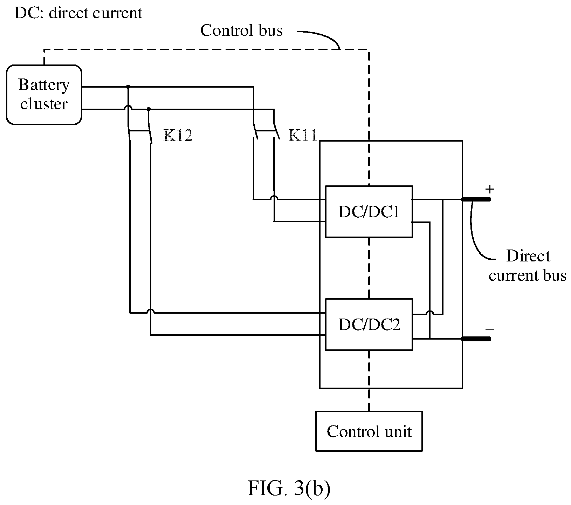

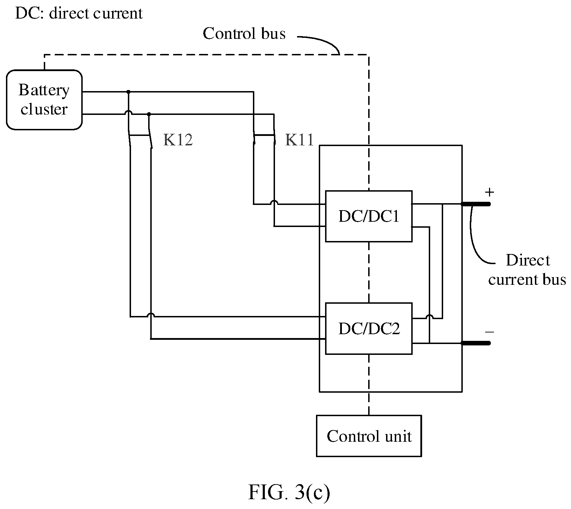

For ease of understanding, refer to FIG. 3(a) to FIG. 3(c). FIG. 3(a) to FIG. 3(c) are a schematic diagram of an application scenario of different rated charge/discharge rates according to an embodiment of this application. As shown in FIG. 3(a) to FIG. 3(c), the energy storage system includes one battery cluster and two DC/DC conversion modules (the DC/DC1 shown in FIG. 2 and DC/DC2). When the control unit controls the switch K11 to be turned on and the switch K12 to be turned off (as shown in FIG. 3(a)), or when the control unit controls the switch K12 to be turned on and the switch K11 to be turned off (as shown in FIG. 3(b)), the rated charge/discharge rate of the energy storage system is XC. When the control unit controls both the switch K11 and the switch K12 to be turned on (as shown in FIG. 3(c)), the rated charge/discharge rate of the energy storage system is 2XC. In other words, when the rated charge/discharge rate of the energy storage system is XC, the one battery cluster in the energy storage system is correspondingly connected to one DC/DC conversion module; when the rated charge/discharge rate of the energy storage system is 2XC, the one battery cluster in the energy storage system is correspondingly connected to two DC/DC conversion modules.

Optionally, in some feasible implementations, when the energy storage system includes at least two battery clusters, an output end of each of the at least two battery clusters may be connected to an input end of each DC/DC conversion module by using a switch. The control unit is connected to each battery cluster and each DC/DC conversion module by using a control bus. The control unit is configured to control turn-on or turn-off of a switch used by each battery cluster to connect to each DC/DC conversion module, to enable connections between different battery clusters and different DC/DC conversion modules. That is, an output end of each of the at least two battery clusters is connected to an input end of each of the at least two DC/DC conversion modules by using a switch, and output ends of the at least two DC/DC conversion modules are connected in parallel to a direct current bus. The control unit is connected to the at least two battery clusters and each of the at least two DC/DC conversion modules by using the control bus, to control charging and discharging of the at least two battery clusters and control each of the at least two DC/DC conversion modules to perform direct current conversion. The control unit is further configured to control turn-on or turn-off of a switch used by each of the at least two battery clusters to connect to each of the at least two DC/DC conversion modules, to control connections between each of the at least two battery clusters and different quantities of DC/DC conversion modules, thereby controlling a rated charge/discharge rate of the energy storage system.

It can be understood that an example in which the energy storage system includes at least two battery clusters and the at least two battery clusters include a first battery cluster and a second battery cluster is used. The control unit is configured to control a switch, which is used by the first battery cluster to connect to h DC/DC conversion modules in the at least two DC/DC conversion modules, to be turned on, control a switch, which is used by the first battery cluster to connect to a DC/DC conversion module that is other than the h DC/DC conversion modules and that is in the at least two DC/DC conversion modules, to be turned off, and control a switch, which is used by the second battery cluster to connect to each of the at least two DC/DC conversion modules, to be turned off, thereby controlling a charge/discharge current of the energy storage system, so that the rated charge/discharge rate of the energy storage system is a target rated charge/discharge rate, where h is an integer greater than 0. For example, if one battery cluster is correspondingly connected to one DC/DC conversion module (that is, h=1), the rated charge/discharge rate of the energy storage system is XC; or if one battery cluster is correspondingly connected to two DC/DC conversion modules (that is, h=2), the rated charge/discharge rate of the energy storage system is 2XC. A magnitude of X is determined based on specifications of the battery cluster and the DC/DC conversion module. In other words, if a battery cluster in the energy storage system does not join in running, that is, the battery cluster is not correspondingly connected to any DC/DC conversion module, a quantity of DC/DC conversion modules correspondingly connected to each running battery cluster is controlled to be 1 or greater than 1, so that different rated charge/discharge rates of the energy storage system can also be controlled.

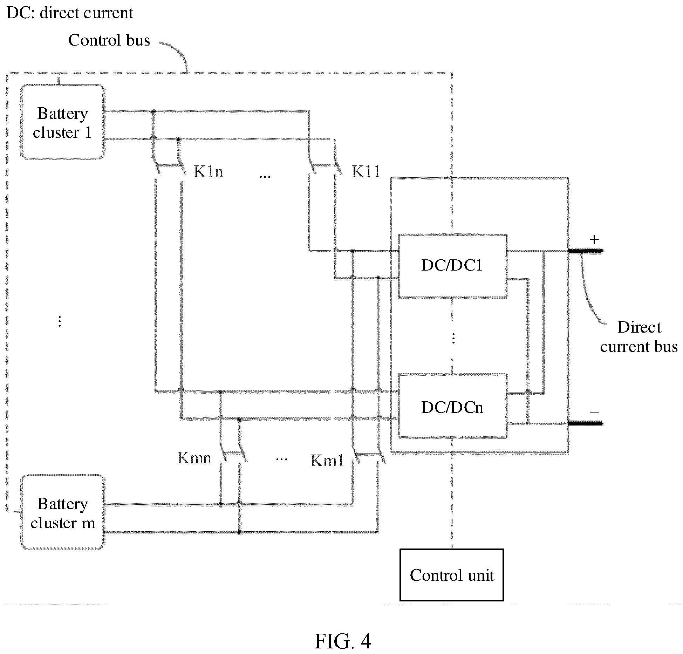

For ease of understanding, refer to FIG. 4. FIG. 4 is a schematic diagram of another structure of an energy storage system according to this application. As shown in FIG. 4, the energy storage system includes m battery clusters, n DC/DC conversion modules, and a control unit, where m is an integer greater than or equal to 1, and n is an integer greater than 1. Herein, an example in which m is an integer greater than 1 is used for description. The m battery clusters may be a battery cluster 1, ..., and a battery cluster m. The n DC/DC conversion modules may be a DC/DC conversion module 1, ..., and a DC/DC conversion module n. An output end of the battery cluster 1 may be connected to the DC/DC conversion module 1 (DC/DC1 shown in FIG. 4) by using a switch K11, the output end of the battery cluster 1 may be further connected to a DC/DC conversion module 2 (not shown in FIG. 4) by using a switch K12 (not shown in FIG. 4), ..., and the output end of the battery cluster 1 may be further connected to the DC/DC conversion module n (DC/DCn shown in FIG. 4) by using a switch K1n. An output end of a battery cluster 2 (not shown in FIG. 4) may be connected to the DC/DC conversion module 1 by using a switch K21 (not shown in FIG. 4), the output end of the battery cluster 2 may be further connected to the DC/DC conversion module 2 by using a switch K22 (not shown in FIG. 4), ..., and the output end of the battery cluster 2 may be further connected to the DC/DC conversion module n by using a switch K2n (not shown in FIG. 4). The rest may be deduced by analogy. An output end of the battery cluster m may be connected to the DC/DC conversion module 1 by using a switch Km1, the output end of the battery cluster m may be further connected to the DC/DC conversion module 2 by using a switch Km2, ..., and the output end of the battery cluster m may be further connected to the DC/DC conversion module n by using a switch Kmn. The control unit is connected to each battery cluster and each DC/DC conversion module by using a control bus. The control unit is configured to control turn-on or turn-off of a switch used by each battery cluster to connect to each DC/DC conversion module, to enable connections between different battery clusters and different DC/DC conversion modules, thereby controlling a rated charge/discharge rate of the energy storage system.

For example, m is equal to 2, and n is equal to 2. When either of the two battery clusters included in the energy storage system is correspondingly connected to one DC/DC conversion module, or when each battery cluster is correspondingly connected to one different DC/DC conversion module, the rated charge/discharge rate of the energy storage system is XC. When either one of the two battery clusters included in the energy storage system is correspondingly connected to the two DC/DC conversion modules, and the other battery cluster does not run (that is, the other battery cluster is not correspondingly connected to any DC/DC conversion module), the rated charge/discharge rate of the energy storage system is 2XC.

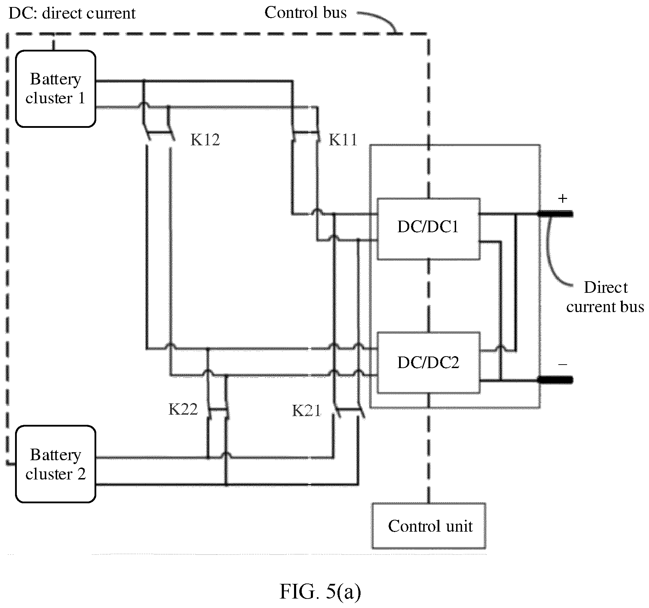

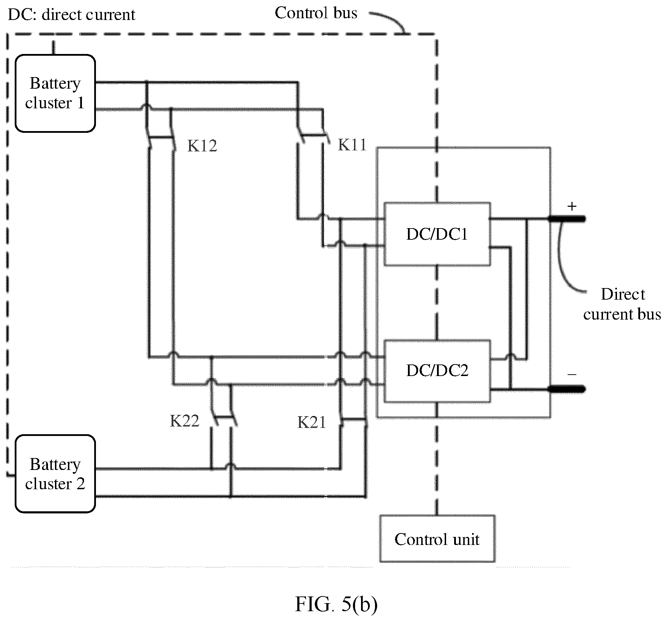

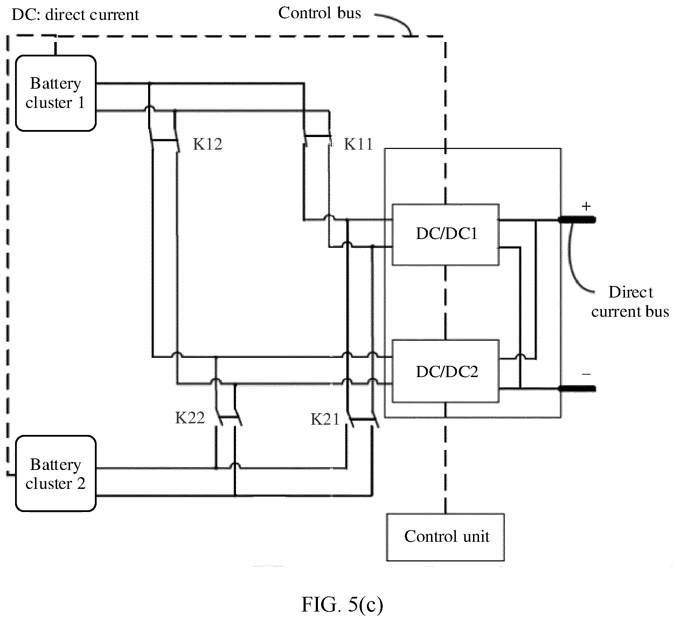

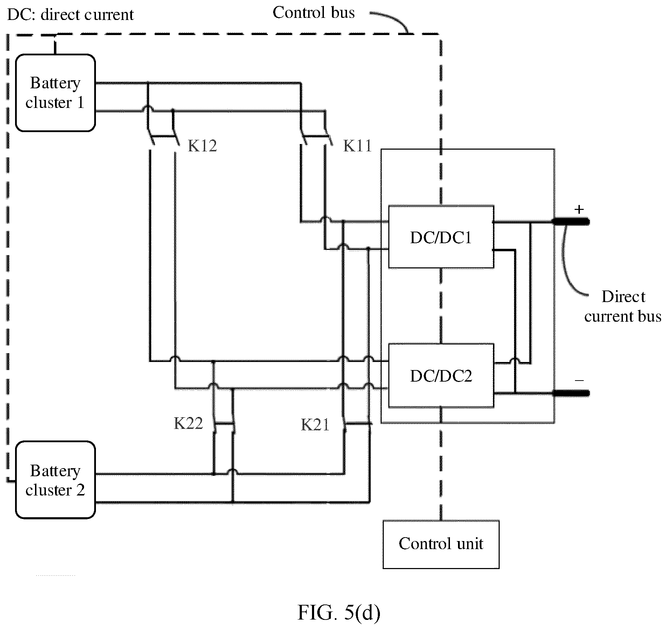

For example, refer to FIG. 5(a) to FIG. 5(d). FIG. 5(a) to FIG. 5(d) are a schematic diagram of another application scenario of different rated charge/discharge rates according to an embodiment of this application. When the control unit controls the switch K11 to be turned on and the switches K12, K21, and K22 to be turned off, or when the control unit controls the switch K12 to be turned on and the switches K11, K21, and K22 to be turned off, or when the control unit controls the switch K21 to be turned on and the switches K11, K12, and K22 to be turned off, or when the control unit controls the switch K22 to be turned on and the switches K11, K12, and K21 to be turned off, or when the control unit controls the switches K11 and K22 to be turned on and the switches K12 and K21 to be turned off (as shown in FIG. 5(a)), or when the control unit controls the switches K12 and K21 to be turned on and the switches K11 and K22 to be turned off (as shown in FIG. 5(b)), the rated charge/discharge rate of the energy storage system is XC. When the control unit controls both the switch K11 and the switch K12 to be turned on and both the switch K21 and the switch K22 to be turned off (as shown in FIG. 5(c)), or when the control unit controls both the switch K21 and the switch K22 to be turned on and both the switch K11 and the switch K12 to be turned off (as shown in FIG. 5(d)), the rated charge/discharge rate of the energy storage system is 2XC. It can be learned from FIG. 5(c) that, when the rated charge/discharge rate of the energy storage system is 2XC, the battery cluster 1 is correspondingly connected to the two DC/DC conversion modules, and the battery cluster 2 is not correspondingly connected to any DC/DC conversion module, that is, the battery cluster 2 does not run. It can be learned from FIG. 5(d) that, when the rated charge/discharge rate of the energy storage system is 2XC, the battery cluster 2 is correspondingly connected to the two DC/DC conversion modules, and the battery cluster 1 is not correspondingly connected to any DC/DC conversion module, that is, the battery cluster 1 does not run.

For another example, m is equal to 2 (that is, the two battery clusters are the battery cluster 1 and the battery cluster 2), and n is equal to 4 (that is, the four DC/DC conversion modules are the DC/DC1, DC/DC2, DC/DC3, and DC/DC4). When either of the two battery clusters included in the energy storage system is correspondingly connected to one DC/DC conversion module, or when each battery cluster is correspondingly connected to one different DC/DC conversion module, the rated charge/discharge rate of the energy storage system is XC. When either of the two battery clusters included in the energy storage system is correspondingly connected to two DC/DC conversion modules, or when each battery cluster is correspondingly connected to a different pair of DC/DC conversion modules, the rated charge/discharge rate of the energy storage system is 2XC. Optionally, when either one of the at least two battery clusters included in the energy storage system is correspondingly connected to three DC/DC conversion modules, and the other battery cluster does not run, the rated charge/discharge rate of the energy storage system is 3XC; or when either one of the at least two battery clusters included in the energy storage system is correspondingly connected to the four DC/DC conversion modules, and the other battery cluster does not run, the rated charge/discharge rate of the energy storage system is 4XC.

Optionally, in some feasible implementations, to meet an actual power supply requirement of an electric device, the battery cluster in the energy storage system may include battery modules connected in series, in parallel, or in a series-parallel manner. This is specifically determined based on an actual application scenario, and is not limited herein. All the embodiments of this application are described by using an example in which all battery modules in a battery cluster are connected in series. Specifically, each battery cluster may include at least one battery module connected in series. Each battery module includes one battery management unit (BMU). Therefore, the control unit may be connected to a BMU of each battery module in each battery cluster by using the control bus, and the control unit is configured to obtain an initial state of charge (SOC) of each battery cluster by using a BMU of each battery module. Usually, all battery modules in a same battery cluster have a same model and a same initial state of charge, that is, the initial state of charge of each battery module is also an initial state of charge of the battery cluster.

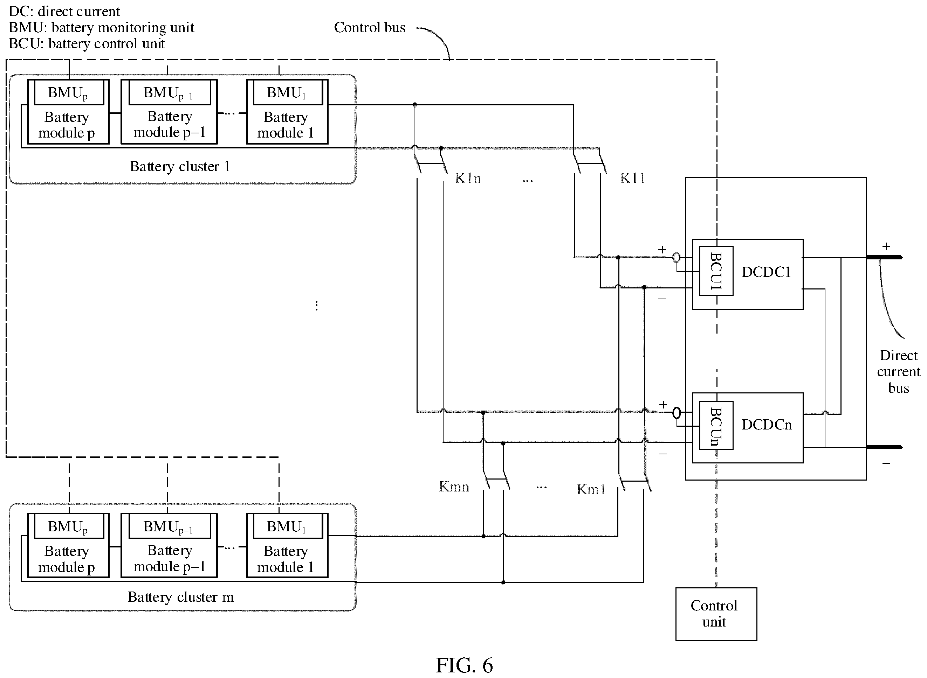

Optionally, in some feasible implementations, each of the at least two DC/DC conversion modules may include one battery control unit BCU, the control unit is connected to each BCU in each DC/DC conversion module by using the control bus, and the control unit is configured to obtain an output current magnitude of each battery cluster by using each BCU. That is, the BCU in this application is integrated into the DC/DC conversion module, to collect a current flowing through a DC/DC battery side (that is, an output current magnitude of the battery cluster), communicate with the BMU, the control unit, and the like, calculate an SOC, manage a battery module in each battery cluster, and the like. This is not limited herein. For ease of understanding, refer to FIG. 6. FIG. 6 is a schematic diagram of another structure of an energy storage system according to this application. As shown in FIG. 6, the energy storage system includes m battery clusters, n DC/DC conversion modules, and a control unit, where both m and n are integers greater than 1. An output end of each of the m battery clusters is connected to an input end of each DC/DC conversion module by using a switch. Each of the m battery clusters includes p battery modules connected in series, where p is an integer greater than 0. Each battery module includes one BMU, to collect signals such as a cell voltage, a temperature, an initial SOC, and a state of health (state of health, SOH) value in the battery module. Each of the n DC/DC conversion modules includes one BCU. All BMUs included in each battery cluster are connected to a BMU in any DC/DC conversion module in a hand-in-hand communications connection manner. All BMUs included in each DC/DC conversion module may also be connected to the control unit in a hand-in-hand communications connection manner. It can be understood that, in this application, a communication type between the BMU, the BCU, and the control unit may be a daisy chain, a CAN, Wi-Fi, or the like. This is not limited herein. The control unit may estimate information such as a current state of charge of the battery cluster based on an initial state of charge collected by the BMU and a current collected by the BCU.

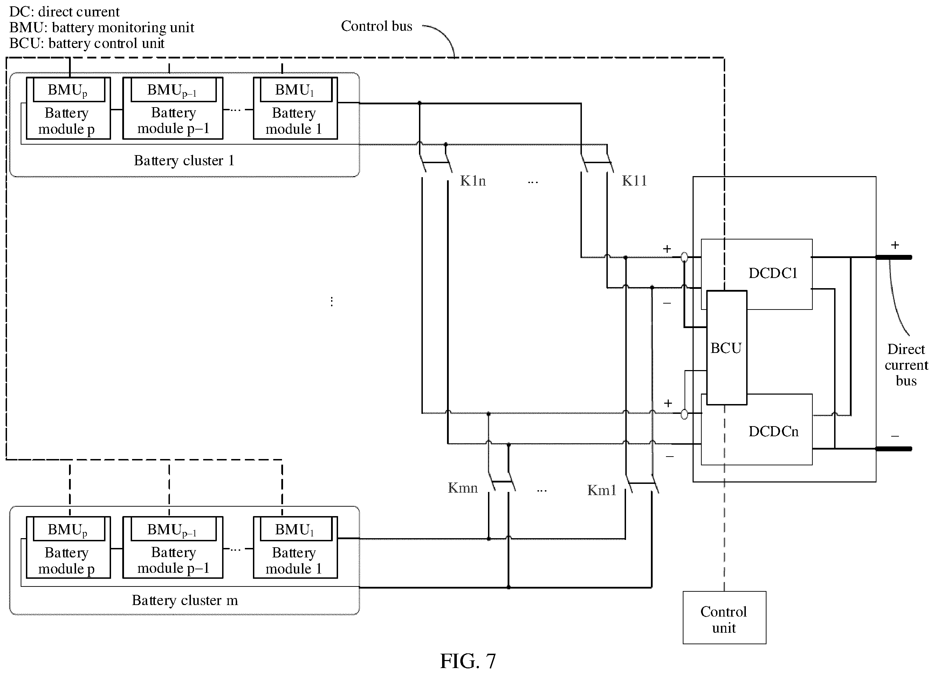

Optionally, in some feasible implementations, alternatively, the at least two DC/DC conversion modules may include one battery control unit BCU, the control unit is connected to the BCU by using a control bus, and the control unit is configured to obtain an output current magnitude of each battery cluster by using the BCU. In other words, the plurality of DC/DC conversion modules included in the energy storage system may alternatively reuse one BCU. The BCU may be configured to collect an output current of each battery cluster, communicate with the BMU, the control unit, and the like, calculate an SOC, manage a battery module in each battery cluster, and the like. This is not limited herein. For ease of understanding, refer to FIG. 7. FIG. 7 is a schematic diagram of another structure of an energy storage system according to this application. As shown in FIG. 7, the energy storage system includes m battery clusters, n DC/DC conversion modules, and a control unit, where both m and n are integers greater than 1. An output end of each of the m battery clusters is connected to an input end of each DC/DC conversion module by using a switch. Each of the m battery clusters includes p battery modules connected in series, where p is an integer greater than 0. Each battery module includes one BMU, to collect signals such as a cell voltage, a temperature, an initial SOC, and an SOH in the battery module. The n DC/DC conversion modules reuse one BCU. All BMUs included in each battery cluster are connected to the BCU in a hand-in-hand communications connection manner, and the BCU is connected to the control unit by using a control bus. The control unit may estimate information such as a current state of charge of the battery cluster based on an initial state of charge collected by the BMU and a current collected by the BCU. It can be understood that, when all the DC/DC conversion modules reuse one BCU, all BMUs in each battery cluster may be connected to the BCU in a hand-in-hand communications connection manner. Then, a current state of charge of each battery cluster is estimated based on an output current of the battery cluster collected by the BCU and an initial state of charge of the battery cluster, to control charging and discharging of each battery cluster based on a current state of charge of the battery cluster, thereby balancing remaining power of each battery cluster. It can be understood that the BMU, the BCU, the control unit, and the like in the embodiments of this application constitute a BMS, and this is different from a related technology in which charging and discharging control is performed on an energy storage system by using an external BMS. The energy storage system provided in this application has a higher degree of integration and higher compatibility.

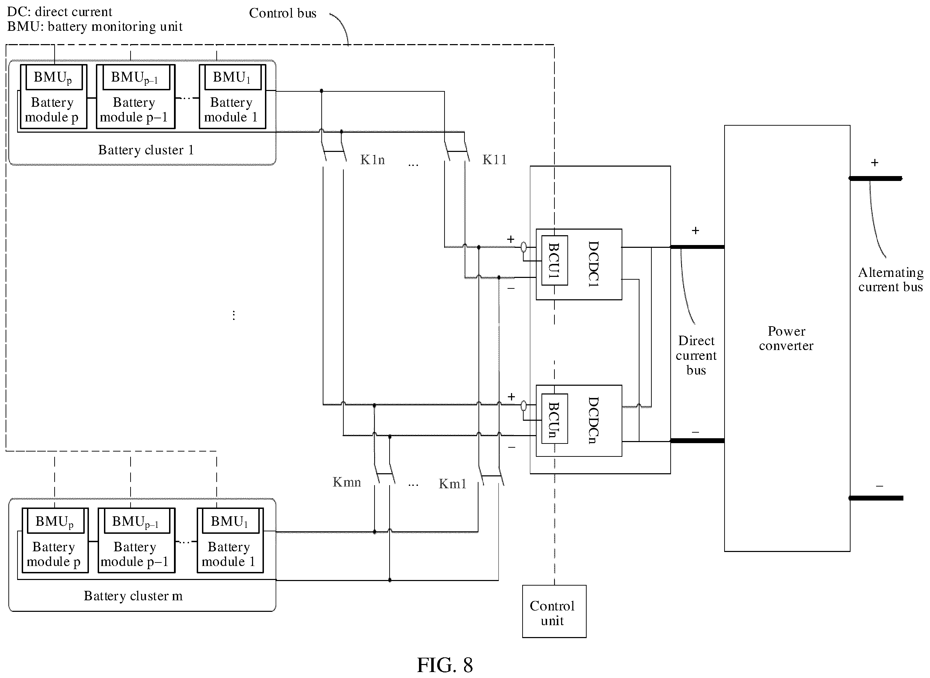

Optionally, in some feasible implementations, the energy storage system may further include a power converter. For example, refer to FIG. 8. FIG. 8 is a schematic diagram of another structure of an energy storage system according to this application. As shown in FIG. 8, an input end of a power converter is connected to a direct current bus, and an output end of the power converter is connected to an alternating current bus. The power converter is configured to convert, into alternating current electricity during discharging of a battery cluster, direct current electricity that is input based on the direct current bus, or the power converter is configured to convert, into direct current electricity during charging of a battery cluster, alternating current electricity that is input based on the alternating current bus. Usually, the power converter may be further connected to a transformer, a power grid, or an alternating current load by using the alternating current bus. Therefore, during discharging of the battery cluster, the battery cluster in the energy storage system may provide a direct current input voltage for each DC/DC conversion module connected to the battery cluster, and the DC/DC conversion module performs power conversion on the direct current input voltage and outputs direct current electric energy to the power converter. In this case, the power converter may perform power conversion on direct current electric energy that is input from each DC/DC conversion module, and output alternating current electric energy to the power grid or the alternating current load (for example, a household device), so as to supply power to the power grid or the alternating current load. The power converter may be a neutral-point-clamped T-type three-level inverter, an active neutral-point-clamped inverter, a flying capacitor multilevel inverter, or the like. This is not limited herein. It can be understood that the energy storage system in this application may include at least one power converter. A specification of the selected power converter may be determined based on an actual application scenario. This is not limited herein.

In the embodiments of this application, turn-on and turn-off of switches used for connections between the battery cluster and the DC/DC conversion modules are controlled by using the control unit, so as to control a quantity of DC/DC conversion modules correspondingly connected to the battery cluster, thereby controlling the rated charge/discharge rate of the energy storage system, to adapt to scenarios requiring various rated charge/discharge rates. This reduces development costs of an energy storage system with different rated charge/discharge rates. In addition, the energy storage system can further implement independent charging and discharging control of each battery cluster, to implement battery balancing, that is, balance remaining power of each battery cluster, thereby avoiding battery damage caused by overcharge or overdischarge of a battery cluster. This improves reliability and stability of the energy storage system.

The following describes in detail an energy storage system control method provided in this application.

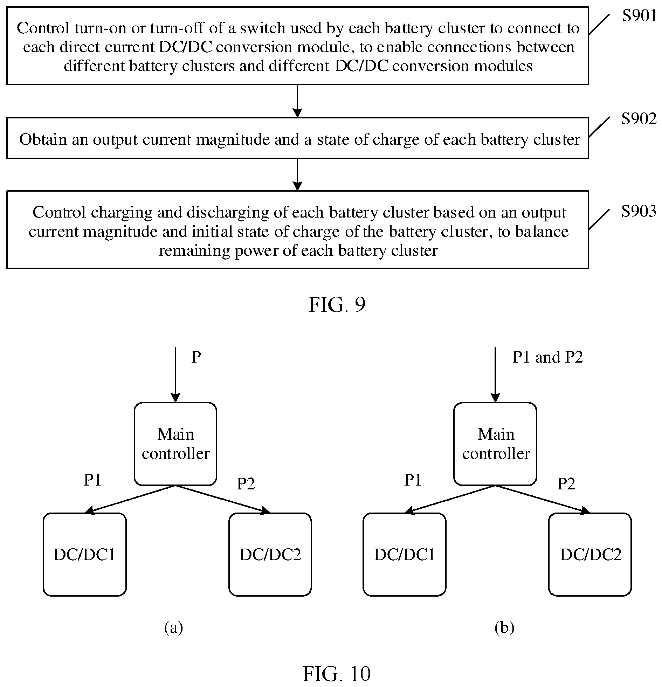

FIG. 9 is a schematic flowchart of an energy storage system control method according to this application. The method is applicable to an energy storage system (for example, the energy storage system provided in FIG. 2 to FIG. 8). For ease of description, in this embodiment of this application, the energy storage system shown in FIG. 4 is used as an example for description. The energy storage system includes at least two battery clusters, at least two direct current DC/DC conversion modules, and a control unit. An output end of each of the at least two battery clusters is connected to an input end of each DC/DC conversion module by using a switch. Output ends of the at least two DC/DC conversion modules are connected in parallel to a direct current bus. The control unit is connected to each battery cluster and each DC/DC conversion module by using a control bus. As shown in FIG. 9, the method includes step S901 to step S903 below.

S901: Control turn-on or turn-off of a switch used by each battery cluster to connect to each DC/DC conversion module, to enable connections between different battery clusters and different DC/DC conversion modules.

In some feasible implementations, the control unit may send a switch control instruction, thereby controlling turn-on or turn-off of a switch used by each battery cluster to connect to each DC/DC conversion module, to enable connections between different battery clusters and different DC/DC conversion modules. For example, with reference to FIG. 5(a) to FIG. 5(d), the energy storage system includes two battery clusters and two DC/DC conversion modules. It is assumed that the two battery clusters are a battery cluster 1 and a battery cluster 2, and the two DC/DC conversion modules are DC/DC1 and DC/DC2. As shown in FIG. 5(a) to FIG. 5(d), an output end of the battery cluster 1 may be connected to the DC/DC conversion module 1 (the DC/DC1 shown in FIG. 5(a) to FIG. 5(d)) by using the switch K11, and the output end of the battery cluster 1 may be further connected to the DC/DC conversion module 2 (the DC/DC2 shown in FIG. 5(a) to FIG. 5(d)) by using the switch K12; and an output end of the battery cluster 2 may be connected to the DC/DC conversion module 1 (the DC/DC1 shown in FIG. 5(a) to FIG. 5(d)) by using the switch K21, and the output end of the battery cluster 2 may be further connected to the DC/DC conversion module 2 (the DC/DC2 shown in FIG. 5(a) to FIG. 5(d)) by using the switch K22. When the control unit turns on the switch K11 and the switch K22 and turns off the switch K12 and the switch K21 (as shown in FIG. 5(a)) by using the switch control instruction, or turns on the switch K12 and the switch K21 and turns off the switch K11 and the switch K22 (as shown in FIG. 5(b)) by using the switch control instruction, a rated charge/discharge rate of the energy storage system is XC. When the control unit turns on the switch K11 and the switch K12 and turns off the switch K21 and the switch K22 (as shown in FIG. 5(c)) by using the switch control instruction, or when the control unit turns on the switch K21 and the switch K22 and turns off the switch K11 and the switch K12 (as shown in FIG. 5(d)) by using the switch control instruction, a rated charge/discharge rate of the energy storage system is 2XC.

S902: Obtain an output current magnitude and initial state of charge of each battery cluster.

In some feasible implementations, the control unit may obtain an output current magnitude and initial state of charge of each battery cluster. Specifically, the control unit may use a BCU in the DC/DC conversion module to collect an output current magnitude of each battery cluster, and use a BMU in each battery module in each battery cluster to collect an initial state of charge of the battery module. In this embodiment of this application, each battery cluster includes at least one battery module connected in series. Usually, all battery modules in a same battery cluster are of a same model and have a same initial state of charge, that is, an initial state of charge of each battery module in a same battery cluster is equivalent to an initial state of charge of the battery cluster. Therefore, the control unit may determine, as an initial state of charge of the battery cluster, an initial state of charge of any battery module obtained by using a BMU. The BCU in the DC/DC conversion module may be configured to collect an output current of each battery cluster. Therefore, the control unit may obtain an output current magnitude of each battery cluster by using each BCU. Optionally, when the plurality of DC/DC conversion modules reuse one BCU, an output current magnitude of each battery cluster may be obtained based on the one BCU. This is specifically determined based on an actual application scenario, and is not limited herein.

S903: Control charging and discharging of each battery cluster based on an output current magnitude and initial state of charge of the battery cluster, to balance remaining power of each battery cluster.

In some feasible implementations, the control unit may control charging and discharging of each battery cluster based on an output current magnitude and initial state of charge of the battery cluster, to balance remaining power of each battery cluster. Specifically, the controlling charging and discharging of each battery cluster based on an output current magnitude and initial state of charge of the battery cluster may be understood as: controlling, based on an output current magnitude and initial state of charge of each battery cluster, operating power of each DC/DC conversion module correspondingly connected to the battery cluster, to control charging and discharging of each battery cluster. The controlling, based on an output current magnitude and initial state of charge of each battery cluster, operating power of each DC/DC conversion module correspondingly connected to the battery cluster may be understood as: determining, based on an output current magnitude and initial state of charge of any battery cluster, a first state of charge corresponding to the any battery cluster; and controlling, based on a first state of charge corresponding to each battery cluster, operating power of each DC/DC conversion module correspondingly connected to the battery cluster, to control charging and discharging of each battery cluster.

For ease of understanding, the following describes in detail a process of estimating the first state of charge.

In some feasible implementations, a BMU integrated in a battery module of each battery cluster records an initial state of charge of the battery module. Usually, all battery modules in a same battery cluster have a same model and a same initial state of charge, that is, the initial state of charge of each battery module is also an initial state of charge of the battery cluster. It can be understood that a BCU in each DC/DC conversion module may independently sample a current flowing through a DC/DC battery side. For example, with reference to FIG. 5(a) to FIG. 5(d), the energy storage system includes two DC/DC conversion modules (that is, the DC/DC1 and the DC/DC2). A BCU1 in the DC/DC1 and a BCU2 in the DC/DC2 may respectively collect currents $I_1$ and $I_2$ at a first sampling interval t1 and a second sampling interval t2, and then the collected currents are accumulated, to calculate state-of-charge variations $\Delta$SOC1 and $\Delta$SOC2. Specifically, $\Delta$SOC1 and

$\Delta$SOC2 satisfy the following:

$$\begin{cases} \Delta SOC1 = \sum_{0}^{N1} I_1 * t_1 / Ah_0 \\ \Delta SOC2 = \sum_{0}^{N2} I_2 * t_2 / Ah_0 \end{cases}$$

Herein, N1 represents a quantity of current sampling times of the BCU1, N2 represents a quantity of current sampling times of the BCU2, and $Ah_0$ represents a rated battery capacity.

For ease of understanding, the energy storage system shown in FIG. 5(a) to FIG. 5(d) is used as an example. It is assumed that the energy storage system shown in FIG. 5(a) to FIG. 5(d) is a 2XC system (that is, the rated charge/discharge rate of the energy storage system is 2XC). In this case, currents sampled by the BCU1 and the BCU2 are actually from a same battery cluster (which may be, for example, the battery cluster 1 (as shown in FIG. 5(c)) or the battery cluster 2 (as shown in FIG. 5(d))). Therefore, a calculation formula of a current state of charge (that is, a first state of charge) of the battery cluster is:

$$SOC = SOC0 + \Delta SOC1 + \Delta SOC2.$$

Herein, SOC represents the first state of charge, and SOC0 is an initial state of charge of the battery cluster (that is, an initial state of charge of any battery module detected by using a BMU).

If the energy storage system is an XC system (that is, the rated charge/discharge rate of the energy storage system is XC), currents sampled by the BCU1 and the BCU2 are respectively from the battery cluster 1 and the battery cluster 2 (as shown in FIG. 5(a)). Therefore, calculation formulas of current states of charge of the battery cluster 1 and the battery cluster 2 are:

$$\begin{cases} SOC1 = SOC_0^1 + \Delta SOC1 \\ SOC2 = SOC_0^2 + \Delta SOC2 \end{cases}.$$

Herein, SOC1 is a current state of charge of the battery cluster 1 (that is, a first state of charge corresponding to the battery cluster 1), $SOC_0^1$ is an initial state of charge of the battery cluster 1, SOC2 is a current state of charge of the battery cluster 2 (that is, a first state of charge corresponding to the battery cluster 2), and $SOC_0^2$ is an initial state of charge of the battery cluster 2.

In some feasible implementations, after determining a first state of charge of each battery cluster, the control unit may control, based on a first state of charge corresponding to each battery cluster, operating power of each DC/DC conversion module correspondingly connected to the battery cluster, to control charging and discharging of each battery cluster. It can be understood that, in this embodiment of this application, each DC/DC conversion module runs independently, but all of the DC/DC conversion modules are controlled by a same main controller. FIG. 10 is a schematic diagram of controlling a DC/DC conversion module according to this application. A main controller in FIG. 10 may be understood as a main controller included in a direct current converter. For ease of understanding, in this embodiment of this application, the energy storage system shown in FIG. 5(a) to FIG. 5(d) is still used as an example for description. The energy storage system includes two battery clusters and two DC/DC conversion modules. The two battery clusters are the battery cluster 1 and the battery cluster 2, and the two DC/DC conversion modules are the DC/DC1 and the DC/DC2. As shown in (a) in FIG. 10, in a 2XC scenario (for example, a scenario shown in FIG. 5(c) or a scenario shown in FIG. 5(d)), only one battery cluster (the battery cluster 1 or the battery cluster 2) in the energy storage system is running, and the battery cluster is correspondingly connected to the two DC/DC conversion modules. Therefore, the main controller may receive one power control instruction P from the control unit, and then evenly allocate the instruction to the DC/DC1 and the DC/DC2, that is, power control instructions received by the DC/DC1 and the DC/DC2 satisfy P1=P2=P/2. As shown in (b) in FIG. 10, in an XC scenario (for example, a scenario shown in FIG. 5(a) or a scenario shown in FIG. 5(b)), the two battery clusters in the energy storage system are both in a running state, that is, each battery cluster is correspondingly connected to one DC/DC conversion module. Therefore, the main controller may receive two control instructions P1 and P2 from the control unit, to respectively control operating power of the DC/DC1 and operating power of the DC/DC2. In other words, a quantity of power control instructions received by the main controller from the control unit is the same as a quantity of actually running battery clusters. Power magnitudes indicated by the power control instructions P1 and P2 correspond to the current states of charge (that is, the first states of charge) of the battery cluster 1 and the battery cluster 2. Specifically, during discharging of the energy storage system, a power control instruction magnitude is directly proportional to an SOC of a battery cluster, that is, (P1, P2)∝(SOC1, SOC2). During charging of the energy storage system, a power control instruction magnitude is directly proportional to (100%-SOC) of a battery cluster, that is, (P1, P2)∝(100%-SOC1, 100%-SOC2). In other words, the control unit may control, based on a first state of charge corresponding to each battery cluster, operating power of each DC/DC conversion module correspondingly connected to the battery cluster, to control charging and discharging of each battery cluster, thereby balancing remaining power of each battery cluster.

In this embodiment of this application, the control unit controls turn-on or turn-off of a switch used by each battery cluster to connect to each DC/DC conversion module, to enable connections between different battery clusters and different DC/DC conversion modules, so that the energy storage system can have different rated charge/discharge rates. Further, in an actual running phase, the control unit obtains an output current magnitude and initial state of charge of each battery cluster, and can determine a current state of charge (that is, a first state of charge) of each battery cluster based on an output current magnitude and initial state of charge of the battery cluster. Then, the control unit controls charging and discharging of each battery cluster based on a current state of charge of the battery cluster, to balance remaining power of each battery cluster, thereby avoiding overcharge and overdischarge of the battery cluster. This helps improve stability and reliability of the energy storage system, and makes the energy storage system more applicable.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. An energy storage system, wherein the energy storage system comprises at least one battery cluster, at least two direct current, DC/DC conversion modules, and a control unit, wherein

an output end of each of the at least one battery cluster is connected to an input end of each of the at least two DC/DC conversion modules by using a switch, and output ends of the at least two DC/DC conversion modules are connected in parallel to a direct current bus; and
the control unit is connected to the at least one battery cluster and each of the at least two DC/DC conversion modules by using a control bus, to control charging and discharging of the at least one battery cluster and control each of the at least two DC/DC conversion modules to perform direct current conversion; and the control unit is further configured to control turn-on or turn-off of a switch used by each of the at least one battery cluster to connect to each of the at least two DC/DC conversion modules, to control connections between each of the at least one battery cluster and different quantities of DC/DC conversion modules, thereby controlling a rated charge/discharge rate of the energy storage system,

wherein the at least one battery cluster comprises a first battery cluster;

**characterised in that** the control unit is configured to control a switch, which is used by the first battery cluster to connect to a first DC/DC conversion module in the at least two DC/DC conversion modules, to be turned on, and control a switch, which is used by the first battery cluster to connect to a DC/DC conversion module that is other than the first DC/DC conversion module and that is in the at least two DC/DC conversion modules, to be turned off, thereby controlling a charge/discharge current of the energy storage system, so that the rated charge/discharge rate of the energy storage system is a first rated charge/discharge rate.

2. The energy storage system according to claim 1, wherein the control unit is further configured to control switches, which are used by the first battery cluster to connect to n DC/DC conversion modules in the at least two DC/DC conversion modules, to be turned on, and control a switch, which is used by the first battery cluster to connect to a DC/DC conversion module that is other than the n DC/DC conversion modules and that is in the at least two DC/DC conversion modules, to be turned off, thereby controlling a charge/discharge current of the energy storage system, so that the rated charge/discharge rate of the energy storage system is a second rated charge/discharge rate, wherein the n DC/DC conversion modules or the another DC/DC conversion module comprise/comprises the first DC/DC conversion module, the second rated charge/discharge rate is n times the first rated charge/discharge rate, and n is an integer greater than 1.

3. The energy storage system according to claim 1, wherein the energy storage system comprises at least two battery clusters, and the at least two battery clusters comprise a first battery cluster and a second battery cluster; and

the control unit is configured to control a switch, which is used by the first battery cluster to connect to h DC/DC conversion modules in the at least two DC/DC conversion modules, to be turned on, control a switch, which is used by the first battery cluster to connect to a DC/DC conversion module that is other than the h DC/DC conversion modules and that is in the at least two DC/DC conversion modules, to be turned off, and control a switch, which is used by the second battery cluster to connect to each of the at least two DC/DC conversion modules, to be turned off, thereby controlling a charge/discharge current of the energy storage system, so that the rated charge/discharge rate of the energy storage system is a target rated charge/discharge rate, wherein h is an integer greater than 0.

4. The energy storage system according to any one of claims 1 to 3, wherein the control unit is further configured to control charging and discharging of each of the at least one battery cluster based on an output current magnitude and initial state of charge of the battery cluster, to balance remaining power of each battery cluster.

5. The energy storage system according to claim 4, wherein each battery cluster comprises at least one battery module connected in series, each battery module comprises one battery management unit, BMU, the control unit is connected to a BMU of each battery module in each battery cluster by using the control bus, and the control unit is configured to obtain an initial state of charge of each battery cluster by using a BMU of each battery module.

6. The energy storage system according to claim 4, wherein each of the at least two DC/DC conversion modules comprises one battery control unit, BCU, the control unit is connected to each BCU in the DC/DC conversion modules by using the control bus, and the control unit is configured to obtain an output current magnitude of each battery cluster by using each BCU.

7. The energy storage system according to claim 4, wherein the at least two DC/DC conversion modules comprise one battery control unit BCU, the control unit is connected to the BCU by using the control bus, and the control unit is configured to obtain an output current magnitude of each battery cluster by using the BCU.

8. The energy storage system according to any one of claims 1 to 7, wherein the energy storage system further comprises a power converter, an input end of the power converter is connected to the direct current bus, an output end of the power converter is connected to an alternating current bus, and the power converter is configured to convert, into alternating current electricity during discharging of the battery cluster, direct current electricity that is input based on the direct current bus, or the power converter is configured to convert, into direct current electricity during charging of the battery cluster, alternating current electricity that is input based on the alternating current bus.

9. An energy storage system control method, wherein the method is applicable to an energy storage system, and the energy storage system comprises at least one battery cluster, at least two direct current DC/DC conversion modules, and a control unit, wherein

an output end of each of the at least one battery cluster is connected to an input end of each of the at least two DC/DC conversion modules by using a switch, output ends of the at least two DC/DC conversion modules are connected in parallel to a direct current bus, the control unit is connected to the at least one battery cluster and each of the at least two DC/DC conversion modules by using a control bus, and the method comprises:

controlling (S901) turn-on or turn-off of a switch used by each of the at least one battery cluster to connect to each of the at least two DC/DC conversion modules, to control connections between each of the at least one battery cluster and different quantities of DC/DC conversion modules;

obtaining (902) an output current magnitude and initial state of charge of each battery cluster; and controlling (903) charging and discharging of each battery cluster based on an output current magnitude and initial state of charge of the battery cluster, to balance remaining power of each battery cluster,

wherein the at least one battery cluster comprises a first battery cluster,

**characterised in that**

the method further comprises controlling, by the control unit, a switch, which is used by the first battery cluster to connect to a first DC/DC conversion module in the at least two DC/DC conversion modules, to be turned on, and controlling, by the control unit, a switch, which is used by the first battery cluster to connect to a DC/DC conversion module that is other than the first DC/DC conversion module and that is in the at least two DC/DC conversion modules, to be turned off, thereby controlling a charge/-discharge current of the energy storage system, so that the rated charge/discharge rate of the energy storage system is a first rated charge/-discharge rate.

10. The method according to claim 9, wherein the controlling charging and discharging of each battery cluster based on an output current magnitude and initial state of charge of the battery cluster comprises: controlling, based on an output current magnitude and initial state of charge of each battery cluster, operating power of each DC/DC conversion module correspondingly connected to the battery cluster, to control charging and discharging of each battery cluster.

11. The method according to claim 10, wherein the controlling, based on an output current magnitude and initial state of charge of each battery cluster, operating power of each DC/DC conversion module correspondingly connected to the battery cluster comprises:

determining, based on an output current magnitude and initial state of charge of any battery cluster, a first state of charge corresponding to the any battery cluster; and controlling, based on a first state of charge corresponding to each battery cluster, operating power of each DC/DC conversion module correspondingly connected to the battery cluster, to control charging and discharging of each battery cluster.

**Patentansprüche**

1. Energiespeichersystem, wobei das Energiespeichersystem mindestens einen Batteriecluster, mindestens zwei Gleichstrom(DC/DC)-Wandlermodule und eine Steuereinheit umfasst, wobei

ein Ausgangsende jedes des mindestens einen Batterieclusters durch Verwenden eines Schalters mit einem Eingangsende jedes der mindestens zwei DC/DC-Wandlermodule verbunden ist, und Ausgangsenden der mindestens zwei DC/DC-Wandlermodule mit einem Gleichstrombus parallelgeschaltet sind; und die Steuereinheit durch Verwenden eines Steuerbusses mit dem mindestens einen Batteriecluster und jedem der mindestens zwei DC/DC-Wandlermodule verbunden ist, um ein Laden und Entladen des mindestens einen Batterieclusters zu steuern und jedes der mindestens zwei DC/DC-Wandlermodule zu steuern, um eine Gleichstromwandlung durchzuführen; und die Steuereinheit ferner konfiguriert ist, um ein Einschalten oder Ausschalten eines Schalters zu steuern, der durch jeden des mindestens einen Batterieclusters verwendet wird, um sich mit jedem der mindestens zwei DC/DC-Wandlermodule zu verbinden, um Verbindungen zwischen jedem des mindestens einen Batterieclusters und unterschiedlichen Mengen von DC/DC-Wandlermodulen zu steuern, wodurch eine Nennlade-/entladerate des Energiespeichersystems gesteuert wird, wobei der mindestens eine Batteriecluster einen ersten Batteriecluster umfasst; **dadurch gekennzeichnet, dass** die Steuereinheit konfiguriert ist, um einen Schalter, der durch den ersten Batteriecluster verwendet wird, um sich mit einem ersten DC/DC-Wandlermodul in den mindestens zwei DC/DC-Wandlermodulen zu verbinden, so zu steuern, dass er eingeschaltet wird, und einen Schalter, der durch den ersten Batteriecluster verwendet wird, um sich mit einem DC/DC-Wandlermodul zu verbinden, das von dem ersten DC/DC-Wandlermodul verschieden ist und das in den mindestens zwei DC/DC-Wandlermodulen ist, so zu steuern, dass er ausgeschaltet wird, wodurch ein Lade-/Entladestrom des Energiespeichersystems gesteuert wird, sodass die Nennlade-/entladerate des Energiespeichersystems eine erste Nennlade-/entladerate ist.

2. Energiespeichersystem nach Anspruch 1, wobei die Steuereinheit ferner konfiguriert ist, um Schalter, die durch den ersten Batteriecluster verwendet werden, um sich mit n DC/DC-Wandlermodulen in den mindestens zwei DC/DC-Wandlermodulen zu verbinden, so zu steuern, dass sie eingeschaltet werden, und einen Schalter, der durch den ersten Batteriecluster verwendet wird, um sich mit einem DC/DC-Wandlermodul zu verbinden, das von den n DC/DC-Wandlermodulen verschieden ist und das in den mindestens zwei DC/DC-Wandlermodulen ist, so zu steuern, dass er ausgeschaltet wird, wodurch ein Lade-/Entladestrom des Energiespeichersystems gesteuert wird, sodass die Nennlade-/entladerate des Energiespeichersystems eine zweite Nennlade-/entladerate ist, wobei die n DC/DC-Wandlermodule oder das andere DC/DC-Wandlermodul das erste DC/DC-Wandlermodul umfassen/umfasst, die zweite Nennlade-/entladerate das n-fache der ersten Nennlade-/entladerate ist, und n eine ganze Zahl größer als 1 ist.

3. Energiespeichersystem nach Anspruch 1, wobei das Energiespeichersystem mindestens zwei Batteriecluster umfasst, und die mindestens zwei Batteriecluster einen ersten Batteriecluster und einen zweiten Batteriecluster umfassen; und
die Steuereinheit konfiguriert ist, um einen Schalter, der durch den ersten Batteriecluster verwendet wird, um sich mit h DC/DC-Wandlermodulen in den mindestens zwei DC/DC-Wandlermodulen zu verbinden, so zu steuern, dass er eingeschaltet wird, einen Schalter, der durch den ersten Batteriecluster verwendet wird, um sich mit einem DC/DC-Wandlermodul zu verbinden, das von den h DC/DC-Wandlermodulen verschieden ist und das in den mindestens zwei DC/DC-Wandlermodulen ist, so zu steuern, dass er ausgeschaltet wird, und einen Schalter, der durch den zweiten Batteriecluster verwendet wird, um sich mit jedem der mindestens zwei DC/DC-Wandlermodule zu verbinden, so zu steuern, dass er ausgeschaltet wird, wodurch ein Lade-/Entladestrom des Energiespeichersystems gesteuert wird, sodass die Nennlade-/entladerate des Energiespeichersystems eine Zielnennlade-/entladerate ist, wobei h eine ganze Zahl größer als 0 ist.

4. Energiespeichersystem nach einem der Ansprüche 1 bis 3, wobei die Steuereinheit ferner konfiguriert ist, um das Laden und Entladen jedes des mindestens einen Batterieclusters basierend auf einer Ausgangsstromgröße und einem anfänglichen Ladezustand des Batterieclusters zu steuern, um die verbleibende Leistung jedes Batterieclusters auszugleichen.

5. Energiespeichersystem nach Anspruch 4, wobei jeder Batteriecluster mindestens ein in Reihe geschaltetes Batteriemodul umfasst, jedes Batteriemodul eine Batteriemanagementeinheit, BMU, umfasst, die Steuereinheit mit einer BMU jedes Batteriemoduls in jedem Batteriecluster durch Verwenden des Steuerbusses verbunden ist, und die Steuereinheit konfiguriert ist, um einen anfänglichen Ladezustand jedes Batterieclusters durch Verwenden einer BMU jedes Batteriemoduls zu erhalten.

6. Energiespeichersystem nach Anspruch 4, wobei jedes der mindestens zwei DC/DC-Wandlermodule eine Batteriesteuereinheit, BCU, umfasst, die Steuereinheit mit jeder BCU in den DC/DC-Wandlermodulen durch Verwenden des Steuerbusses verbunden ist, und die Steuereinheit konfiguriert ist, um eine Ausgangsstromgröße jedes Batterieclusters durch Verwenden jeder BCU zu erhalten.

7. Energiespeichersystem nach Anspruch 4, wobei die mindestens zwei DC/DC-Wandlermodule eine Batteriesteuereinheit BCU umfassen, die Steuereinheit mit der BCU durch Verwenden des Steuerbusses verbunden ist, und die Steuereinheit konfiguriert ist, um eine Ausgangsstromgröße jedes Batterieclusters durch Verwenden der BCU zu erhalten.

8. Energiespeichersystem nach einem der Ansprüche 1 bis 7, wobei das Energiespeichersystem ferner einen Leistungswandler umfasst, ein Eingangsende des Leistungswandlers mit dem Gleichstrombus verbunden ist, ein Ausgangsende des Leistungswandlers mit einem Wechselstrombus verbunden ist, und der Leistungswandler konfiguriert ist, um während des Entladens des Batterieclusters Gleichstrom, der basierend auf dem Gleichstrombus eingegeben wird, in Wechselstrom umzuwandeln, oder der Leistungswandler konfiguriert ist, um während des Ladens des Batterieclusters Wechselstrom, der basierend auf dem Wechselstrombus eingegeben wird, in Gleichstrom umzuwandeln.

9. Energiespeichersystemsteuerungsverfahren, wobei das Verfahren auf ein Energiespeichersystem anwendbar ist, und das Energiespeichersystem mindestens einen Batteriecluster, mindestens zwei Gleichstrom(DC/DC)-Wandlermodule, und eine Steuereinheit umfasst, wobei

ein Ausgangsende jedes des mindestens einen Batterieclusters durch Verwenden eines Schalters mit einem Eingangsende jedes der mindestens zwei DC/DC-Wandlermodule verbunden ist, Ausgangsenden der mindestens zwei DC/DC-Wandlermodule mit einem Gleichstrombus parallelgeschaltet sind, die Steuereinheit durch Verwenden eines Steuerbusses mit dem mindestens einen Batteriecluster und jedem der mindestens zwei DC/DC-Wandlermodule verbunden ist, und das Verfahren umfasst:

> Steuern (S901) des Einschaltens oder Ausschaltens eines Schalters, der durch jeden des mindestens einen Batterieclusters verwendet wird, um sich mit jedem der mindestens zwei DC/DC-Wandlermodule zu verbinden, um Verbindungen zwischen jedem des mindestens einen Batterieclusters und unterschiedlichen Mengen von DC/DC-Wandlermodulen zu steuern;
> Erhalten (902) einer Ausgangsstromgröße und eines anfänglichen Ladezustands jedes Batterieclusters; und
> Steuern (903) des Ladens und Entladens jedes Batterieclusters basierend auf einer Ausgangsstromgröße und einem anfänglichen Ladezustand des Batterieclusters, um die verbleibende Leistung jedes Batterieclusters auszugleichen, wobei der mindestens eine Batteriecluster einen ersten Batteriecluster umfasst,
> **dadurch gekennzeichnet, dass** das Verfahren ferner das Steuern, durch die Steuereinheit, eines Schalters, der durch den ersten Batteriecluster verwendet wird, um sich mit einem ersten DC/DC-Wandlermodul in den mindestens zwei DC/DC-Wandlermodulen zu verbinden, sodass er eingeschaltet wird, und das Steuern, durch die Steuereinheit, eines Schalters umfasst, der durch den ersten Batteriecluster verwendet wird, um sich mit einem DC/DC-Wandlermodul zu verbinden, das von dem ersten DC/DC-Wandlermodul verschieden ist und das in den mindestens zwei DC/DC-Wandlermodulen ist, sodass er ausgeschaltet wird, wodurch ein Lade-/Entladestrom des Energiespeichersystems gesteuert wird, sodass die Nennlade-/entladerate des Energiespeichersystems eine erste Nennlade-/entladerate ist.

10. Verfahren nach Anspruch 9, wobei das Steuern des Ladens und Entladens jedes Batterieclusters basierend auf einer Ausgangsstromgröße und einem anfänglichen Ladezustand des Batterieclusters umfasst:
Steuern, basierend auf einer Ausgangsstromgröße und einem anfänglichen Ladezustand jedes Batterieclusters, einer Betriebsleistung jedes DC/DC-Wandlermoduls, das entsprechend mit dem Batteriecluster verbunden ist, um das Laden und Entladen jedes Batterieclusters zu steuern.

11. Verfahren nach Anspruch 10, wobei das Steuern, basierend auf einer Ausgangsstromgröße und einem anfänglichen Ladezustand jedes Batterieclusters, der Betriebsleistung jedes DC/DC-Wandlermoduls, das entsprechend mit dem Batteriecluster verbunden ist, umfasst:

> Bestimmen, basierend auf einer Ausgangsstromgröße und einem anfänglichen Ladezustand eines beliebigen Batterieclusters, eines ersten Ladezustands, der dem beliebigen Batteriecluster entspricht; und
> Steuern, basierend auf einem ersten Ladezustand, der jedem Batteriecluster entspricht, der Betriebsleistung jedes DC/DC-Wandlermoduls, das entsprechend mit dem Batteriecluster verbunden ist, um das Laden und Entladen jedes Batterieclusters zu steuern.

## Revendications

1. Système de stockage d'énergie, dans lequel le système de stockage d'énergie comprend au moins un groupe de batteries, au moins deux modules de conversion de courant continu, CC/CC, et une unité de commande, dans lequel

> une extrémité de sortie de chacun de l'au moins un groupe de batteries est connectée à une extrémité d'entrée de chacun des au moins deux modules de conversion CC/CC à l'aide d'un commutateur, et des extrémités de sortie des au moins deux modules de conversion CC/CC sont connectées en parallèle à un bus de courant continu ; et
> l'unité de commande est connectée à l'au moins un groupe de batteries et à chacun des au moins deux modules de conversion CC/CC à l'aide d'un bus de commande, pour commander la charge et la décharge de l'au moins un groupe de batteries et commander chacun des au moins deux modules de conversion CC/CC pour effectuer une conversion de courant continu ; et l'unité de commande est en outre configurée pour commander l'activation ou la désactivation d'un commutateur utilisé par chacun de l'au moins un groupe de batteries pour se connecter à chacun des au moins deux modules de conversion CC/CC, pour commander les connexions entre chacun de l'au moins un groupe de batteries et différentes quantités de modules de conversion CC/CC, commandant ainsi un taux de charge/décharge nominal du système de stockage d'énergie,

dans lequel l'au moins un groupe de batteries comprend un premier groupe de batteries ; **caractérisé en ce que** l'unité de commande est configurée pour commander un commutateur, qui est utilisé par le premier groupe de batteries pour se connecter à un premier module de conversion CC/CC dans les au moins deux modules de conversion CC/CC, à activer, et pour commander un commutateur, qui est utilisé par le premier groupe de batteries pour se connecter à un module de conversion CC/CC qui est autre que le premier module de conversion CC/CC et qui est dans les au moins deux modules de conversion CC/CC, à désactiver, en commandant de ce fait un courant de charge/décharge du système de stockage d'énergie, de sorte que le taux de charge/décharge nominal du système de stockage d'énergie est un premier taux de charge/décharge nominal.

2. Système de stockage d'énergie selon la revendication 1, dans lequel l'unité de commande est en outre configurée pour commander des commutateurs, qui sont utilisés par le premier groupe de batteries pour se connecter à n modules de conversion CC/CC dans les au moins deux modules de conversion CC/CC, à activer, et commander un commutateur, qui est utilisé par le premier groupe de batteries pour se connecter à un module de conversion CC/CC qui est autre que les n modules de conversion CC/CC et qui se trouve dans les au moins deux modules de conversion CC/CC, à désactiver, en commandant de ce fait un courant de charge/décharge du système de stockage d'énergie, de sorte que le taux de charge/décharge nominal du système de stockage d'énergie est un second taux de charge/décharge nominal, dans lequel les n modules de conversion CC/CC ou l'autre module de conversion CC/CC comprennent/comprend le premier module de conversion CC/CC, le second taux de charge/décharge nominal est de n fois le premier taux de charge/décharge nominal, et n est un nombre entier supérieur à 1.

3. Système de stockage d'énergie selon la revendication 1, dans lequel le système de stockage d'énergie comprend au moins deux groupes de batteries, et les au moins deux groupes de batteries comprennent un premier groupe de batteries et un second groupe de batteries ; et

l'unité de commande est configurée pour commander un commutateur, qui est utilisé par le premier groupe de batteries pour se connecter à h modules de conversion CC/CC dans les au moins deux modules de conversion CC/CC, à activer, pour commander un commutateur, qui est utilisé par le premier groupe de batteries pour se connecter à un module de conversion CC/CC qui est autre que les h modules de conversion CC/CC et qui est dans les au moins deux modules de conversion CC/CC, à désactiver, et commander un commutateur, qui est utilisé par le second groupe de batteries pour se connecter à chacun des au moins deux modules de conversion CC/CC, à désactiver, en commandant de ce fait un courant de charge/décharge du système de stockage d'énergie, de sorte que le taux de charge/décharge nominal du système de stockage d'énergie est un taux de charge/décharge nominal cible, dans lequel h est un nombre entier supérieur à 0.

4. Système de stockage d'énergie selon l'une quelconque des revendications 1 à 3, dans lequel l'unité de commande est en outre configurée pour commander la charge et la décharge de chacun de l'au moins un groupe de batteries sur la base d'une magnitude de courant de sortie et d'un état de charge initial du groupe de batteries, afin d'équilibrer la puissance restante de chaque groupe de batteries.

5. Système de stockage d'énergie selon la revendication 4, dans lequel chaque groupe de batteries comprend au moins un module de batterie connectée en série, chaque module de batterie comprend une unité de gestion de batterie, BMU, l'unité de commande est connectée à une BMU de chaque module de batterie dans chaque groupe de batteries à l'aide du bus de commande, et l'unité de commande est configurée pour obtenir un état de charge initial de chaque groupe de batteries à l'aide d'une BMU de chaque module de batterie.

6. Système de stockage d'énergie selon la revendication 4, dans lequel chacun des au moins deux modules de conversion CC/CC comprend une unité de commande de batterie, BCU, l'unité de commande est connectée à chaque BCU dans les modules de conversion CC/CC à l'aide du bus de commande, et l'unité de commande est configurée pour obtenir une magnitude de courant de sortie de chaque groupe de batteries à l'aide de chaque BCU.

7. Système de stockage d'énergie selon la revendication 4, dans lequel les au moins deux modules de conversion CC/CC comprennent une unité de commande de batterie, BCU, l'unité de commande est connectée à la BCU à l'aide du bus de commande, et l'unité de commande est configurée pour obtenir une magnitude de courant de sortie de chaque groupe de batteries en utilisant la BCU.

8. Système de stockage d'énergie selon l'une quelconque des revendications 1 à 7, dans lequel le système de stockage d'énergie comprend en outre un convertisseur de puissance, une extrémité d'entrée du convertisseur de puissance est connectée au bus de courant continu, une extrémité de sortie du convertisseur de puissance est connecté à un bus de courant alternatif, et le convertisseur de puissance est configuré pour convertir, en électricité à courant alternatif pendant la décharge du groupe de batteries, l'électricité à courant continu qui est entrée en fonction du bus de courant continu, ou le convertisseur de puissance est configuré pour convertir, en électricité à courant continu pendant la charge du groupe de batteries, l'électricité à courant alternatif qui est entrée sur la base du bus à courant alternatif.

9. Procédé de commande d'un système de stockage d'énergie, dans lequel le procédé est applicable à un système de stockage d'énergie, et le système de stockage d'énergie comprend au moins un groupe de batteries, au moins deux modules de conversion CC/CC à courant continu, et une unité de commande, dans lequel une extrémité de sortie de chacun de l'au moins un groupe de batteries est connectée à une extrémité d'entrée de chacun des au moins deux modules de conversion CC/CC à l'aide d'un commutateur, les extrémités de sortie des au moins deux modules de conversion CC/CC sont connectées en parallèle à un bus de courant continu, l'unité de commande est connectée à l'au moins un groupe de batteries et à chacun des au moins deux modules de conversion CC/CC modulaires à l'aide d'un bus de commande, et le procédé comprend :

la commande (S901) d'activation ou de désactivation d'un commutateur utilisé par chacun de l'au moins un groupe de batteries pour se connecter à chacun des au moins deux modules de conversion CC/CC, pour commander des connexions entre chacun de l'au moins un groupe de batteries et différentes quantités de modules de conversion CC/CC ;

l'obtention (902) d'une magnitude de courant de sortie et d'un état de charge initial de chaque groupe de batteries ; et

la commande (903) de la charge et de la décharge de chaque groupe de batteries sur la base d'une magnitude de courant de sortie et d'un état de charge initial du groupe de batteries, afin d'équilibrer la puissance restante de chaque groupe de batteries,

dans lequel l'au moins un groupe de batteries comprend un premier groupe de batteries, **caractérisé en ce que** le procédé comprend en outre la commande, par l'unité de commande, d'un commutateur, qui est utilisé par le premier groupe de batteries pour se connecter à un premier module de conversion CC/CC dans les au moins deux modules de conversion CC/CC, à activer, et la commande, par l'unité de commande, d'un commutateur, qui est utilisé par le premier groupe de batteries pour se connecter à un module de conversion CC/CC qui est autre que le premier module de conversion CC/CC et qui se trouve dans les au moins deux modules de conversion CC/CC, à désactiver, et la commande de ce fait d'un courant de charge/décharge du système de stockage d'énergie, de sorte que le taux de charge/décharge nominal du système de stockage d'énergie est un premier taux de charge/décharge nominal.

10. Procédé selon la revendication 9, dans lequel la commande de la charge et de la décharge de chaque groupe de batteries sur la base d'une magnitude de courant de sortie et d'un état de charge initial du groupe de batteries comprend :
la commande, sur la base d'une magnitude de courant de sortie et d'un état de charge initial de chaque groupe de batteries, de la puissance de fonctionnement de chaque module de conversion CC/CC connecté de façon correspondante au groupe de batteries, pour commander la charge et la décharge de chaque groupe de batteries.

11. Procédé selon la revendication 10, dans lequel la commande, sur la base d'une magnitude de courant de sortie et d'un état de charge initial de chaque groupe de batteries, de la puissance de fonctionnement de chaque module de conversion CC/CC connecté de façon correspondante au groupe de batteries comprend :

la détermination, sur la base d'une magnitude de courant de sortie et d'un état de charge initial de n'importe quel groupe de batteries, d'un premier état de charge correspondant à l'un quelconque groupe de batteries ; et
la commande, sur la base d'un premier état de charge correspondant à chaque groupe de batteries, de la puissance de fonctionnement de chaque module de conversion CC/CC connecté de façon correspondante au groupe de batteries, pour commander la charge et la décharge de chaque groupe de batteries.

Control bus

Battery management system

Battery cluster 1

Battery cluster 1

⋮

Battery cluster m

Combiner cabinet

Power converter

FIG. 1

FIG. 2

DC: direct current

Control bus

Battery cluster

K12

K11

DC/DC1

+

Direct current bus

DC/DC2

−

Control unit

FIG. 3(a)

DC: direct current

Control bus

Battery cluster

K12

K11

DC/DC1

+

Direct current bus

DC/DC2

−

Control unit

FIG. 3(b)

DC: direct current

FIG. 3(c)

FIG. 4

FIG. 5(a)

FIG. 5(b)

DC: direct current

Control bus

Battery cluster 1

K12

K11

DC/DC1

+

Direct current bus

K22

K21

DC/DC2

−

Battery cluster 2

Control unit

FIG. 5(c)

FIG. 5(d)

DC: direct current
BMU: battery monitoring unit
BCU: battery control unit

Control bus

BMU$_p$   BMU$_{p-1}$ ... BMU$_1$
Battery   Battery        Battery
module p  module p−1     module 1

Battery cluster 1

K1n ... K11

+ BCU1 DCDC1

−

+

Direct
current
bus

+ BCUn DCDCn

−

BMU$_p$   BMU$_{p-1}$ ... BMU$_1$
Battery   Battery        Battery
module p  module p−1     module 1

Battery cluster m

Kmn ... Km1

Control
unit

EP 4 300 754 B1

FIG. 6

DC: direct current
BMU: battery monitoring unit
BCU: battery control unit

Control bus

Battery cluster 1

| BMU$_p$ | BMU$_{p-1}$ | ... | BMU$_1$ |

Battery module p · Battery module p−1 · Battery module 1

K1n ... K11

+

DCDC1

−

BCU

+

DCDCn

−

Kmn ... Km1

Battery cluster m

| BMU$_p$ | BMU$_{p-1}$ | ... | BMU$_1$ |

Battery module p · Battery module p−1 · Battery module 1

+

Direct current bus

−

Control unit

FIG. 7

FIG. 8

DC: direct current
BMU: battery monitoring unit

Control bus

Battery cluster 1

BMU$_p$ | BMU$_{p-1}$ | BMU$_1$
Battery module p | Battery module p−1 | Battery module 1

K1n ... K11

Battery cluster m

BMU$_p$ | BMU$_{p-1}$ | BMU$_1$
Battery module p | Battery module p−1 | Battery module 1

Kmn ... Km1

BCU1 | DCDC1

BCUn | DCDCn

+
−

Direct current bus

Power converter

Alternating current bus

+
−

Control unit

EP 4 300 754 B1

Control turn-on or turn-off of a switch used by each battery cluster to connect to each direct current DC/DC conversion module, to enable connections between different battery clusters and different DC/DC conversion modules  ⟋ S901

Obtain an output current magnitude and a state of charge of each battery cluster  ⟋ S902

Control charging and discharging of each battery cluster based on an output current magnitude and initial state of charge of the battery cluster, to balance remaining power of each battery cluster  ⟋ S903

FIG. 9

P

Main controller

P1              P2

DC/DC1          DC/DC2

(a)

P1 and P2

Main controller

P1              P2

DC/DC1          DC/DC2

(b)

FIG. 10

**EP 4 300 754 B1**

**REFERENCES CITED IN THE DESCRIPTION**

**Patent documents cited in the description**

- US 20130038289 A1
- US 20110144822 A1
- EP 3591823 A1
- US 2019317151 A1
- US 20130127399 A1
- US 2019334349 A1
- EP 2779348 B1
- EP 3370322 A1
- US 20130234669 A1
- WO 2013145658 A1